# EUROPÄISCHE PATENTSCHRIFT

(11) **EP 4 381 220 B1**
(45) Veröffentlichungstag und Bekanntmachung des Hinweises auf die Patenterteilung: **21.05.2025**
(21) Anmeldenummer: 22789908.5
(22) Anmeldetag: 21.09.2022
(51) Int. Cl.: F16N 11/08, F16N 13/02, F16N 29/00

(54) **SCHMIERSTOFFSPENDER**
LUBRICANT DISPENSER
DISTRIBUTEUR DE LUBRIFIANT

(30) Priorität: 17.11.2021 DE 102021129977
(43) Veröffentlichungstag der Anmeldung: 12.06.2024
(73) Patentinhaber: Perma-Tec GmbH & Co. KG, 97717 Euerdorf (DE)
(72) Erfinder: ENGELHARDT, Ralf, 97424 Schweinfurt (DE); LENHART, Matthias, 97688 Bad Kissingen (DE)
(74) Vertreter: Andrejewski - Honke Patent- und Rechtsanwälte Partnerschaft mbB
(86) Internationale Anmeldenummer: PCT/EP2022/076261
(87) Internationale Veröffentlichungsnummer: WO 2023/088594

(56) Entgegenhaltungen:
- EP-A1- 0 845 631
- EP-A2- 1 202 424
- DE-A1- 102010 033 954
- DE-A1- 4 422 407
- DE-B4- 102011 056 247
- DE-U1- 202020 100 985
- US-A1- 2011 253 481
- US-A1- 2021 404 601

## Beschreibung

Die Erfindung betrifft einen Schmierstoffspender mit zumindest
- einem Schmierstoffvorrat, z. B. einer mit Schmierstoff befüllten Kartusche,
- einem elektromechanischen Antrieb, z. B. einem Elektromotor, der auf zumindest ein Betätigungselement (z. B. einen Kolben, eine Pumpe oder dergleichen) zum Ausstoßen von Schmierstoff aus dem Schmierstoffvorrat arbeitet,
- einer Batterie (oder Batterieanordnung mit mehreren Batterien), welche eine Batteriespannung zur Verfügung stellt,
- einer Steuerplatinenanordnung, die zumindest eine Hauptplatine mit einer elektronischen Schaltungsanordnung mit zumindest einem zentralen Mikrocontroller und zusätzlichen Funktionsbauteilen sowie Leiterbahnen aufweist, wobei die Steuerplatinenanordnung einerseits mit der Batterie und andererseits mit dem elektromechanischen Antrieb verbunden ist.

Derartige Schmierstoffspender werden beispielsweise zur automatisierten Schmierung von Maschinen- oder Anlagenteilen, wie z. B. Wälzlagern, Gleitlagern, Linearführungen, Ketten oder dergleichen eingesetzt. Die Schmierstoffspender sind beispielsweise mit einer Schmierstelle (z. B. eines Lagers) verbunden und können Schmierstoffe z. B. in Abhängigkeit von der Laufzeit einer Maschine oder in vorgegebenen oder variablen Intervallen abgeben. Als Schmierstoff kommen z. B. Fette oder Öle zum Einsatz. Der Vorratsbehälter wird auch als Kartusche bezeichnet und eine solche Kartusche lässt sich in der Regel lösbar und austauschbar mit einem elektromechanischen Antrieb bzw. einem Gehäuse des Schmierstoffspenders zu einer Baueinheit verbinden, z. B. durch eine Schraubverbindung, Steckverbindung, Rastverbindung, Bajonettverbindung oder dergleichen. Bei dem elektromechanischen Antrieb handelt es sich bevorzugt um einen Elektromotor bzw. der elektromechanische Antrieb oder das Antriebsaggregat weist einen Elektromotor auf. Bei dem Elektromotor handelt es sich vorzugsweise um einen (batteriebetriebenen) Gleichstrommotor. Der elektromechanische Antrieb und die Steuerplatinenanordnung sind in der Regel in einem (gemeinsamen) Gehäuse des Schmierstoffspenders angeordnet, wobei dieses Gehäuse z. B. mit dem Schmierstoffvorrat gekoppelt wird.

Der elektromechanische Antrieb kann z. B. auf ein Betätigungselement arbeiten, welches als Kolben ausgebildet ist, der z. B. in der Schmierstoffkartusche zum Herauspressen des Schmierstoffs geführt ist, wobei der Kolben z. B. an eine Spindel oder dergleichen angeschlossen ist, die von dem elektromechanischen Antrieb angetrieben wird. Die z. B. im Inneren des Gehäuses des Schmierstoffspenders angeordnete Platinenanordnung nimmt eine Schaltungsanordnung als Steuerelektronik des Schmierstoffspenders auf. Über diese Steuerelektronik wird der elektromechanische Antrieb gezielt angesteuert, um z. B. in vorgewählten Spendeintervallen Schmierstoff auszustoßen. Über die Steuerelektronik kann außerdem eine Ermittlung der Temperatur erfolgen, um den Schmierstoff z. B. temperaturabhängig auszustoßen bzw. den Antrieb temperaturabhängig anzusteuern. Ferner können über die Steuerelektronik Anzeigen realisiert werden, z. B. LCD-Anzeigen und/oder LED-Anzeigen sowie ein Bedienfeld zur Einstellung des Schmierstoffspenders.

Ein Schmierstoffspender der eingangs beschriebenen Art mit elektromechanischem Antrieb wird von der Anmelderin z. B. unter der Produktbezeichnung "Star Vario" vermarktet. Die einfache und selbsterklärende Bedienung erfolgt z. B. über ein LCD-Display mit Einstelltastern, sodass Änderungen der Einstellung jederzeit möglich sind. Über den elektromechanischen, wiederverwendbaren Antrieb mit Batterieset erfolgt eine zuverlässige, präzise Schmierstoffabgabe, unabhängig von Temperatur und Gegendruck.

In der DE 10 2011 056 247 B4 und der DE 4422407 A1 wird ein gattungsgemäßer Schmierstoffspender mit einem elektromechanischen Antrieb beschrieben, der über eine Spindel einen Kolben betätigt, wobei in das Gehäuse des Schmierstoffspenders ebenfalls eine Steuerplatine integriert ist.

Ferner ist aus der DE 10 2012 100 035 B4 ein Schmierstoffspender der eingangs beschriebenen Art bekannt, bei dem die Schmierstoffkartusche lösbar mit einem Träger bzw. Gehäuse verbunden ist, welche einen batteriebetriebenen Motor zum Antrieb der Spindel aufnimmt, wobei auch bei dieser Ausführungsform die Spindel mit einem Kolben zum Ausdrücken des Schmierstoffs aus dem Vorrat verbunden ist.

Alternativ zu diesen Ausführungsformen, bei denen der Antrieb über eine Spindel auf einen Kolben als Betätigungselement arbeitet, umfasst die Erfindung aber auch Ausführungsformen, bei denen ein elektromechanischer Antrieb eine Pumpe antreibt, um einen Schmierstoff aus einem Vorratsbehälter zu einem Auslass zu fördern. Eine solche Ausführungsform ist z. B. aus der DE 10 2019 106 681 A1 bekannt.

Die Erfindung betrifft folglich stets einen Schmierstoffspender mit elektromechanischem Antrieb, z. B. mit einem Elektromotor, wobei die Elektromotoren in der Regel als Gleichstrommotoren ausgebildet sind, die über ein oder mehrere Batterien betrieben werden. Solche Schmierstoffspender mit elektromechanischem Antrieb haben sich in der Praxis hervorragend bewährt, da sie insbesondere eine zuverlässige, präzise und variabel einstellbare Schmierstoffabgabe ermöglichen. Sie sind vielfältig in unterschiedlichsten Umgebungen einsetzbar.

Besondere Herausforderungen stellen sich jedoch dann, wenn der Schmierstoffspender in potenziell explosionsgefährdeten Bereichen eingesetzt werden soll, in denen Sicherheit von besonderer Bedeutung ist, z. B. in Bereichen, in denen brennbare Stoffe hergestellt, verarbeitet, transportiert oder gelagert werden. Es kann sich z. B. um potenziell explosionsgefährdete Bereiche in der chemischen und petrochemischen Industrie sowie bei der Erdöl- und Erdgasförderung und im Bergbau handeln. Auch in der Automobilindustrie kennt man potenziell explosionsgefährdete Bereiche, z. B. in der Lackiererei. Ferner sind Kraftwerke und Stahlwerke und Bereiche umfasst, in denen Kohle oder dergleichen transportiert wird, wobei leitender, explosiver Staub auftritt.

Um in solchen Bereichen ein hohes Sicherheitsniveau zu gewährleisten, existieren in der Regel strenge gesetzliche Sicherheitsauflagen und Normen, die von den Betreibern der Anlage einzuhalten sind. Dabei sind explosionsgefährdete Bereiche in verschiedene Zonen unterteilt, die ein unterschiedliches Sicherheitsniveau erfordern, wobei die sogenannte "Zone 0" die größte Gefahr und damit das höchste Sicherheitsniveau betrifft.

Insbesondere in solchen Zonen mit höchstem Sicherheitsniveau werden in der Praxis für die automatisierte Schmierung von Maschinen, Anlagen oder dergleichen elektrochemische Schmierstoffspender eingesetzt, die nicht mit einem elektromotorischen Antrieb, sondern mit elektrochemischen Antrieben arbeiten, die mit elektrochemischen Gaszellen ausgerüstet sind, über die z. B. ein Kolben zum Ausdrücken des Schmierstoffs betätigt wird. Der Einsatz elektrochemischer Schmiersysteme hat sich in potenziell explosionsgefährdeten Bereichen bewährt. Es besteht jedoch grundsätzlich das Bedürfnis, auch elektromechanische Schmiersysteme in potenziell explosionsgefährdeten Bereichen einzusetzen. - Hier setzt die Erfindung ein.

Der Erfindung liegt die Aufgabe zugrunde, einen elektromechanisch betriebenen Schmierstoffspender der eingangs beschriebenen Art zu schaffen, der sich durch eine hohe Eigensicherheit auszeichnet. Bevorzugt soll der Schmierstoffspender auch in potenziell explosionsgefährdeten Bereichen der "Zone 0"einsetzbar sein, d. h. ein EPL-Schutzniveau (Equipment Protection Level) "a" aufweisen.

Zur Lösung dieser Aufgabe lehrt die Erfindung bei einem gattungsgemäßen Schmierstoffspender der eingangs beschriebenen Art, dass die elektronische Schaltungsanordnung in mehrere Schaltungsinseln (sogenannte "Ex-Schutz-Inseln") aufgeteilt ist oder mehrere Schaltungsinseln aufweist, wobei einige oder sämtliche Schaltungsinseln jeweils leistungsbegrenzt sind. Erfindungsgemäß ist folglich vorgesehen, dass die innerhalb der jeweiligen Schaltungsinsel maximal mögliche Leistung auf einen vorgegebenen Maximalwert begrenzt ist.

Die Erfindung geht dabei von der Erkenntnis aus, dass in den elektronischen Komponenten des Schmierstoffspenders und insbesondere auf bzw. in der Steuerplatinenanordnung einerseits übermäßige Temperaturerhöhungen begrenzt bzw. vermieden werden müssen und andererseits eine Funkenbildung vermieden werden muss bzw. die bei der Funkenbildung entstehende Funkenenergie stark begrenzt werden muss.

Die Aufteilung der elektronischen Schaltungsanordnung in mehrere Ex-Schutz-Inseln hat den Vorteil, dass sich die maximal mögliche Leistung in jeder einzelnen Schutzinsel begrenzen lässt, z. B. durch einen leistungsbegrenzenden Vorwiderstand. Sollte in einer durch einen leistungsbegrenzenden Widerstand angeschlossenen Schaltungsinsel z. B. ein Kurzschluss auftreten, so würde in dieser Insel oder dem betroffenen fehlerhaften Teil die maximal mögliche Leistung umgesetzt werden. Durch den Einsatz eines leistungsbegrenzenden Widerstandes wird diese maximal mögliche Leistung reduziert, der Widerstand geht in Leistungsanpassung, sodass die danach verfügbare elektrische Leistung lediglich den reduzierten Wert beträgt, der sich aus P=U²/(4 x R) errechnet. Der leistungsbegrenzende Widerstand wird dann in der Praxis so ausgelegt, dass im Fehlerfall bei Leistungsanpassung die maximal mögliche Leistung nicht höher ist als die für die in der Schaltungsinsel jeweils verwendeten integrierten Schaltkreise maximal erlaubten Verlustleistungen. Um ein besonders hohes Ex-Schutz-Niveau zu erreichen, kann ergänzend ein Sicherheitsfaktor berücksichtigt werden.

Durch die erfindungsgemäßen Maßnahmen besteht insbesondere die Möglichkeit, die Abstände der Leiterbahnen und die Bauteilgrößen innerhalb jeder einzelnen Schutzinsel verhältnismäßig klein zu wählen. Die Abstände von Leiterbahnen und Bauteilen zwischen einzelnen Schutzinseln werden demgegenüber größer gewählt, so dass insgesamt eine unzulässige Erwärmung und Funkenbildungen zuverlässig vermieden werden. So ist bevorzugt vorgesehen, dass die Abstände der Leiterbahnen zwischen einzelnen Schaltungsinseln einen vorgegebenen Mindestabstand nicht unterschreiten, wobei vorzugsweise dieser Mindestabstand größer als der Abstand der Leiterbahnen innerhalb der Schaltungsinseln ist. So lassen sich innerhalb der Schaltungsinseln auch sehr kleine SMD-Bauelemente mit geringem Abstand und insbesondere geringem Abstand der Anschlüsse einsetzen. So lassen sich erfindungsgemäß die jeweiligen Vorgaben aus den relevanten Normen, z. B. aus der Norm IEC 60079-11 umsetzen.

Die Aufteilung der Schaltungsanordnung in mehrere Ex-Schutz-Inseln ist ein wesentlicher Aspekt der Erfindung, auf den im Folgenden noch näher eingegangen wird. Auch wenn erfindungsgemäß die Ex-Schutz-Inseln jeweils leistungsbegrenzt sind, so können innerhalb der Steuerplatinenanordnungen Schaltungsinseln realisiert sein, deren Komponenten eine Leistungsbegrenzung nicht zulassen, z. B. im Falle eines Motors, bei dem der Einsatz eines leistungsbegrenzenden Vorwiderstandes einen so großen Spannungsabfall erzeugen würde, dass die verbleibende Restspannung für den korrekten Betrieb des Motors nicht mehr ausreichen würde. In solchen Schaltungsinseln, bei denen auf eine Leistungsbegrenzung über z. B. einen Widerstand verzichtet wird, ist es zweckmäßig, jeweils eine Temperatursicherung zu realisieren. Auch darauf wird noch eingegangen.

Im Vordergrund steht die Leistungsbegrenzung der einzelnen Schaltungsinseln, und zwar zumindest einiger Schaltungsinseln. Dazu kommen bevorzugt die erwähnten, leistungsbegrenzenden Widerstände, z. B. Vorwiderstände zum Einsatz. Alternativ oder ergänzend kann eine (zusätzliche) Leistungsbegrenzung zwischen einzelnen Schaltungsinseln realisiert werden, und zwar bevorzugt durch einen oder mehrere Widerstände (Zwischenwiderstände), die zwischen den jeweils miteinander verbundenen Schaltungsinseln angeordnet bzw. in die elektrische Verbindung zwischen den jeweiligen Schaltungsinseln integriert sind. So ist z. B. eine (zentrale) Schaltungsinsel mit einem zentralen Mikrocontroller realisiert und eine, mehrere oder alle anderen Schaltungsinseln sind mit dieser zentralen Schaltungsinsel verbunden. Da die einzelnen Schaltungsinseln jeweils separat mit Spannung versorgt werden, ist es vorteilhaft, wenn die zentrale Schaltungsinsel mit dem Mikrocontroller über die genannten Zwischenwiderstände geschützt wird, an denen z. B. im Kurzschlussfall auf einer Schaltungsinsel die Kurzschlussspannung abfällt und damit die zentrale Schaltungsinsel schützt. Zusätzlich zu den oben genannten Vorwiderständen, die bei den erwähnten Schaltungsinseln in die Spannungszuleitung integriert sind, können folglich zwischen einzelnen Schaltungsinseln, die elektrisch bzw. funktionell miteinander verbunden sind, Zwischenwiderstände integriert werden, um eine Schaltungsinsel zu schützen, wenn es in einer benachbarten Schaltungsinsel zu einer Störung kommt.

Die Betriebssicherheit bzw. Eigensicherheit des Schmierstoffspenders lässt sich in bevorzugter Weiterbildung der Erfindung dadurch verbessern, dass die Schaltungsanordnung (insgesamt) mit einer Strombegrenzungseinrichtung versehen oder verbunden ist, die die Gesamtenergie innerhalb der (gesamten) Schaltungsanordnung begrenzt. Zusätzlich zu der Leistungsbegrenzung innerhalb der einzelnen Schutzinseln ist folglich bevorzugt eine Gesamt-Strombegrenzung realisiert, sodass insbesondere die Energie eines bei einem Defekt potentiell entstehenden Funken begrenzt wird. Ziel ist es, auch hier das jeweils gewünschte Ex-Schutz-Niveau zu erreichen, z. B. für den Einsatz in Zone 0. Die Strombegrenzungseinrichtung wird bevorzugt mehrfach redundant ausgelegt. Dazu sind optional mehrere, z. B. zumindest drei Strombegrenzer realisiert, die z. B. parallel geschaltet sind. Durch die Redundanz wird die Betriebssicherheit bzw. Eigensicherheit weiter erhöht, denn selbst bei einem Ausfall oder Defekt eines oder gegebenenfalls auch zweier Strombegrenzer, funktioniert die Gesamt-Strombegrenzungseinrichtung der Schaltungsanordnung zuverlässig, sodass insbesondere zuverlässig eine Begrenzung der Energie innerhalb eines entstehenden Funkens reduziert wird. Optional und besonders bevorzugt umfasst die Strombegrenzungseinrichtung (zusätzlich) eine Sicherung, z. B. eine Schmelzsicherung. Bei Erreichen des maximal erlaubten Stromes wird z. B. über eine Crowbar-Schaltung die Schmelzsicherung kontrolliert zerstört.

In einer alternativen Ausführungsform kann gegebenenfalls auf eine aktive (mehrfachredundante) Strombegrenzungseinrichtung mit aktiven Strombegrenzern verzichtet werden. Es kann ausreichen, zur Strombegrenzung lediglich eine Sicherung, z. B. Schmelzsicherung, oder optional auch mehrere Sicherungen, z. B. Schmelzsicherungen, einzusetzen.

Nach einem weiteren Aspekt der Erfindung ist die Schaltungsanordnung bevorzugt mit einer Spannungsregeleinrichtung versehen oder verbunden, welche die Batteriespannung auf eine geregelte Betriebsspannung reduziert. Eine solche Ausgestaltung ist insbesondere dann vorteilhaft, wenn Bauteile verwendet werden, die mit einer niedrigeren Spannung betrieben werden müssen/ sollen als von der Batterie bzw. den Batterien geliefert. Außerdem können Normen einen Sicherheitsabstand der maximal erlaubten Spannung zu der eingesetzten Spannung fordern. Um diesen erlaubten (Spannungs-)Sicherheitsabstand zu senken, wird eine geregelte Spannungsreduzierung realisiert, wobei auch die Spannungsversorgung für diese Bauteile bevorzugt dreifach redundant ausgeführt wird. So ist vorgesehen, dass die Spannungsregeleinrichtung mehrfach redundant ausgelegt ist und bevorzugt mehrere, z. B. zumindest drei Spannungsregler umfasst, die bevorzugt in Reihe geschaltet sind. Da an den Bauteilen im Falle des Ausfalls der Spannungsregeleinrichtung nicht mehr die reduzierte Spannung (z. B. 3,3 V), sondern die volle Batteriespannung (z. B. 4,5 V) anliegen würde, hat die mehrfach redundante Ausgestaltung den Vorteil, dass tatsächlich Bauteile, z. B. ein Mikrocontroller, eingesetzt werden können, die für die reduzierte Spannung ausgelegt sind und nicht für die höhere Batteriespannung ausgelegt sein müssen. Besonders bevorzugt werden als Spannungsregler sogenannte LDO-Bauteile eingesetzt, d. h. Low-Dropout-Spannungsregler, die bevorzugt als Längsregler ausgestaltet sind. Auf die alternativ eingesetzten Zenerdioden, die zur Spannungsbegrenzung im Ex-Schutz üblicherweise eingesetzt werden, wird vorzugsweise verzichtet.

Der Einsatz der Spannungseinrichtung bzw. der Spannungsregler hat den Vorteil, dass ohne Sicherheitseinbußen Bauteile, z. B. ein Mikrocontroller verwendet werden können, die nur für diese reduzierte Spannung ausgelegt sind. Werden solche Bauteile verwendet, ist die Redundanz jedoch besonders vorteilhaft.

Es besteht im Übrigen die Möglichkeit, die Spannungsregeleinrichtung oder auch jeden einzelnen Spannungsregler als separate Schaltungsinsel leistungsbegrenzt auszugestalten, sodass z. B. die Spannungsregeleinrichtung insgesamt oder bevorzugt jeder einzelne Spannungsregler durch jeweils einen leistungsbegrenzenden Widerstand begrenzt sein kann. Im Falle der Spannungsregler wird ein solcher leistungsbegrenzender Widerstand bevorzugt nicht als Vorwiderstand geschaltet, da ein Spannungsabfall am Vorwiderstand zu einer zu geringen Spannung für die nachfolgenden Bauteile führen könnte. Aus diesem Grund ist es zweckmäßig, einen leistungsbegrenzenden Widerstand in der Masseleitung des Bauteils, z. B. in der Masseleitung des Spannungsreglers (z. B. LDO) vorzusehen, sodass für die zu regelnde Spannung die volle Spannung zur Verfügung steht und nur die Regelschaltung an sich im Strom limitiert wird.

Nach einem weiteren interessanten Aspekt der Erfindung ist optional vorgesehen, dass die Steuerplatinenanordnung nicht nur durch eine einzelne Platine realisiert ist, sondern dass zusätzlich zu der Hauptplatine eine damit verbundene Zusatzplatine vorgesehen ist. So besteht z. B. die Möglichkeit, die Strombegrenzungseinrichtung auf der Zusatzplatine anzuordnen. Alternativ oder ergänzend kann die Spannungsregeleinrichtung teilweise oder vollständig auf der Zusatzplatine angeordnet sein, indem z. B. ein oder mehrere Spannungsregler auf der Zusatzplatine angeordnet sind und gegebenenfalls zumindest ein Spannungsregler auf der Hauptplatine angeordnet ist. Es kann vorteilhaft sein, sämtliche Spannungsregler auf der Zusatzplatine zu realisieren.

Ein erster Vorteil der Ausgestaltung mit Hauptplatine einerseits und Zusatzplatine andererseits liegt darin, dass unterschiedliche Arten und Ausmaße von isolierenden Schutzbeschichtungen der Schaltungen realisierbar sind. Denn zur Erhöhung der Betriebssicherheit bzw. Eigensicherheit kann es vorteilhaft sein, die Schaltungsanordnung bereichsweise oder vollständig mit einer oder mehreren elektrisch isolierenden Schutzbeschichtungen zu versehen. Dieses lässt sich auf Hauptplatine einerseits und Zusatzplatine andererseits unterschiedlich realisieren. So kann es zweckmäßig sein, auf der Hauptplatine vollständig auf eine Schutzbeschichtung zu verzichten und lediglich auf der Zusatzplatine eine Schutzbeschichtung (bereichsweise oder vollständig) vorzusehen. Alternativ liegt es im Rahmen der Erfindung, wenn die Bauteile auf der Hauptplatine zumindest bereichsweise mit einer Schutzbeschichtung, z .B. einem Schutzlack überzogen sind. Damit besteht z. B. die Möglichkeit, die Abstände der Leiterbahnen zwischen einzelnen Schutzinseln zu reduzieren, nämlich in den Bereichen, in denen die Leiterbahnen und Bauteile mit einem (Norm-konformen) Schutzlack überzogen sind. Technisch können Bereiche existieren, in denen die Funktion von Bauteilen durch einen Schutzlack negativ beeinflusst würde, z. B. im Bereich von optischen oder auch mechanischen Bauteilen, z. B. LED-Linsen oder Tastern. Es kann folglich Bereiche geben, in denen vollständig auf eine Schutzbeschichtung verzichtet wird. In diesen Bereichen werden dann verhältnismäßig große Abstände der Bauteile/Leiterbahnen realisiert. In anderen Bereichen der Hauptplatine können Bauteile durch andere Bauteile verdeckt sein, sodass eine Schutzlackierung nicht oder nur schwer möglich ist. Auch in diesen Bereichen, z. B. unter einem Display, können Bauteile und Leiterbahnen so ausgeführt sein, dass sie die normativ vorgeschriebenen Abstände ohne Schutzlack einhalten. Insgesamt kann die Hauptplatine gezielt so ausgestaltet werden, dass möglichst viele Bereiche mit einem Schutzlack versehen werden, sodass in diesen Bereichen die Abstände weiter reduziert werden können. Unabhängig davon ist zu beachten, dass zwischen den Abständen zwischen einzelnen Schutzinseln einerseits und innerhalb der Schutzinseln andererseits unterschieden werden kann. Wie beschrieben besteht aber auch die Möglichkeit, auf der Hauptplatine vollständig auf eine Schutzbeschichtung, z.B. einen Schutzlack, zu verzichten.

Ein besonderer Vorteil der Realisierung einer (separaten) Zusatzplatine besteht darin, dass die Zusatzplatine - unabhängig von der Hauptplatine - mit einer Schutzbeschichtung versehen sein kann, z. B. bereichsweise oder vollständig mit einer Schutzbeschichtung versehen oder ummantelt sein kann. So besteht die Möglichkeit, dass die Zusatzplatine vollständig in ein elektrisch isolierendes Material eingegossen oder auch eingespritzt ist. Es kann auch zweckmäßig sein bzw. ausreichen, die Zusatzplatine lediglich auf einer Platinenseite (vollständig oder bereichsweise) mit einer Beschichtung zu versehen, z. B. mit einer geeigneten Vergussmasse, sodass die Platine z. B. nur einseitig vergossen wird. Zusätzlich zu der elektrischen Isolierung hat der Verguss den Vorteil, dass Wärme durch die Vergussmasse großflächig abgeführt werden kann. Eine möglicherweise entstehende Erwärmung von Bauteilen, die eine Überschreitung der für den Ex-Schutz erlaubten Oberflächentemperatur hervorrufen würde, wird durch den Verguss aufgenommen und dadurch langsam an die Verguss-Oberfläche abgegeben, sodass die Verguss-Oberflächentemperatur innerhalb der erlaubten Grenze verbleibt. Außerdem ermöglicht der Verguss - so wie ein Schutzlack - die Realisierung geringerer Leiterbahn- und Bauteilabstände und -größen.

In einer möglichen, besonders vorteilhaften Ausführungsform werden sämtliche Spannungsregler (z. B. drei Spannungsregler) auf der Zusatzplatine angeordnet. Sämtliche Spannungsregler lassen sich räumlich sehr nahe beieinander auf der Zusatzplatine realisieren, so dass alle Spannungsregler mit einer oder mehreren Temperatursicherungen, z. B. einer gemeinsamen Temperatursicherung ausgerüstet werden können, indem z. B. eine Temperatursicherung über alle drei Spannungsregler geklebt wird. Im Fehlerfall und bei zu hoher Erwärmung löst die Temperatursicherung aus, so dass das Gerät stromlos geschaltet wird. Wie bereits erwähnt, kann die Zusatzplatine teilweise oder vollständig vergossen werden, oder z. B. auf der Oberseite, auf der alle Bauteile angebracht sind, vergossen sein. Grundsätzlich kann es ausreichen, die durch die Spannungsregler entstehende Wärme über den Verguss der Platine zu verteilen, so dass die Vergussoberfläche die für das Schutzniveau erlaubte Temperatur nicht überschreitet. Durch die optional zusätzlich eingesetzte Thermosicherung kann jedoch eine zu große Erwärmung der Vergussmasse selbst verhindert werden, so dass insbesondere vermieden wird, dass die maximal erlaubte Temperatur der Vergussmasse z. B. unmittelbar an einem Spannungsregler überschritten und damit die Vergussmasse geschädigt wird. Denn eine solche Schädigung der Vergussmasse soll vermieden werden, damit die für den Explosionsschutz wichtige Eigenschaft des luftdichten Ausschlusses eines zündfähigen Gasgemisches gewährleistet ist.

Insgesamt besteht die Möglichkeit, die Abstände der Leiterbahnen und Bauteile variabel zu gestalten. Bevorzugt ist vorgesehen, dass zwischen einzelnen Schaltungsinseln ohne eine Schutzbeschichtung ein vorgegebener erster Mindestabstand realisiert ist, der z. B. 1,5 mm betragen kann. Alternativ oder ergänzend kann zwischen einzelnen Schaltungsinseln mit Schutzbeschichtung ein zweiter Mindestabstand realisiert sein, der z. B. 0,5 mm betragen kann. Alternativ oder ergänzend kann innerhalb einer Schaltungsinsel ein dritter Mindestabstand realisiert sein, der z. B. 0,2 mm beträgt, wobei es in diesem Fall nicht darauf ankommt, ob eine Schutzbeschichtung realisiert ist, da im Bereich der Schaltungsinsel die Leistung ohnehin begrenzt wird.

Die Ausgestaltung mit Hauptplatine einerseits und Zusatzplatine andererseits hat darüber hinaus den weiteren Vorteil, dass auf der Hauptplatine alle Bauteile realisiert werden, die für die Funktion eines Schmierstoffspenders unabhängig vom Einsatz in explosionsgefährdeten Bereichen erforderlich sind und dass auf der Zusatzplatine die zusätzlich erforderlichen Bauteile vorgesehen sind, die für den Betrieb des Schmierstoffspenders in explosionsgefährdeten Bereichen erforderlich sind. Die Hauptplatine kann folglich in bevorzugter Ausführungsform auch ohne die Zusatzplatine technisch voll oder im Wesentlichen funktionsfähig sein, dann jedoch für den Einsatz in nicht explosionsgefährdeten Bereichen. Die Zusatzplatine kann z. B. "Huckepack" auf der Hauptplatine angeordnet sein, z. B. auf die Hauptplatine aufgesteckt und/oder gelötet sein. Da der Strombegrenzung und der Spannungsregelung besondere Bedeutung (z. B. für den Ex-Schutz-Einsatz) zukommt, sind bevorzugt die Strombegrenzungseinrichtung und die Spannungsregeleinrichtung vollständig oder teilweise auf der Zusatzplatine angeordnet. Die Strombegrenzungseinrichtung ist vor allem für die Explosionsschutz-Version der Schaltungsanordnung relevant, sodass sie vollständig auf der Zusatzplatine angeordnet sein kann. Eine Spannungsregelung kann ggf. auch dann vorteilhaft sein, wenn der Schmierstoffspender nicht in explosionsgeschützten Bereichen betrieben werden soll. Dann ist jedoch keine Mehrfachredundanz der Spannungsregeleinrichtung erforderlich. Aus dem Grund kann optional zumindest ein Spannungsregler auf der Hauptplatine angeordnetsein, während die weiteren Spannungsregler für die Redundanz auf der Zusatzplatine angeordnet sein können. Bevorzugt werden jedoch sämtliche Spannungsregler (die für die Ex-Schutz-Variante erforderlich sind) auf der Zusatzplatine angeordnet, so dass in diesem Fall auf der Hauptplatine kein Spannungsregler vorgesehen ist. Soll diese Platine jedoch optional in einem nicht-explosionsgeschützten Bereich betrieben werden, so wird auf die Zusatzplatine verzichtet und stattdessen wird die Hauptplatine optional mit einem Spannungsregler ausgerüstet.

In einer weiteren, möglichen Ausführungsform kann es vorteilhaft sein, die Steuerplatinenanordnung mit einer Platinen-Erkennung auszurüsten, die automatisch erkennt, ob eine Zusatzplatine vorgesehen ist, z. B. auf die Hauptplatine aufgesteckt oder aufgelötet bzw. mit der Hauptplatine verbunden ist. Dies lässt sich z. B. dadurch realisieren, dass ein Pin des Mikrocontrollers mit einem Pull-Up-Widerstand betrieben wird. Durch das Verbinden bzw. Auflöten der Zusatzplatine wird dieser Pin auf Masse gelegt und damit wird die (aufgelötete) Zusatzplatine erkannt. Diese Erkennung wird bevorzugt in die Programmierung des Mikrocontrollers, z. B. in die Software, integriert, d. h. die Software erkennt, ob die Zusatzplatine aufgelötet ist. Dieses hat den Vorteil, dass als Ergebnis der Erkennung eine entsprechende Parameteranpassung der Software erfolgen kann. Damit lassen sich z. B. eventuelle Sonderfunktionen in der Ex-Schutz-Variante automatisch aktivieren bzw. die Betriebsweise daran anpassen, ob die Zusatzplatine realisiert ist oder nicht bzw. ob die Platinenanordnung für den Ex-Schutz-Bereich bestimmt ist oder nicht. So wird z. B. eine Funktionalität zur Verfügung gestellt, bei der für die Ex-Schutz-Variante bestimmte Parameter eingehalten werden. Z. B. könnte die maximale Laufzeit begrenzt werden, wenn die Kapazität des Batteriepacks den zusätzlichen Strombedarf für die zusätzliche Ex-Schutz erforderliche Elektronik nicht abdecken kann. Durch die automatische Erkennung ist für diesen Fall keine eigene Software zu erstellen, denn die Parameteranpassung erfolgt automatisch.

Wie bereits erläutert enthält die Schaltungsanordnung mehrere Schaltungsinseln, in denen die Leistung bevorzugt jeweils begrenzt ist. Eine solche Schaltungsinsel kann z. B. den Mikrocontroller als zentrales Bauteil aufnehmen, der z. B. über einen Vorwiderstand leistungsbegrenzt ist. In diese Schaltungsinsel können weitere Bauteile integriert sein als Funktionsbauteile, die jedoch nur über den Mikrocontroller mit Spannung versorgt werden und nicht selbst mit der Batterie oder der Spannungsregeleinrichtung verbunden sind, sodass diese zusätzlichen Bauteile nicht selbst leistungsbegrenzt werden müssen. Dazu wird auf die Figurenbeschreibung verwiesen.

Weitere Schaltungsinseln können jeweils Funktionsbauteile enthalten, die an die reduzierte und geregelte Batteriespannung, d. h. an die Spannungsregeleinrichtung angeschlossen sind und zusätzlich mit dem Mikrocontroller in Verbindung stehen. Bei diesen Bauteilen ist es vorteilhaft, wenn z. B. zwischen der Schaltungsinsel und dem Mikrocontroller ein leistungsbegrenzender Widerstand bzw. Vorwiderstand vorgesehen ist.

Weitere Details und optionale Ausgestaltungen der Schaltungsinseln und deren Bestückung werden beispielhaft in der Figurenbeschreibung erläutert.

Wesentliches Bauteil des Schmierstoffspenders ist der elektromechanische Antrieb, da erfindungsgemäß ein elektromechanischer Schmierstoffspender für den Einsatz in potentiell explosionsgefährdeten Umgebungen realisiert ist. Der elektromechanische Antrieb ist vorzugsweise als Gleichstrommotor ausgebildet oder mit einem solchen Gleichstrommotor ausgerüstet. Besonders bevorzugt wird als Antrieb ein bürstenloser Gleichstrommotor (BLDC-Motor) verwendet. Diese Motorvariante verzichtet auf die bei anderen Motortypen vorgesehenen Bürsten, sodass die Entstehung von Bürstenfeuer vermieden wird. Dieses ist insbesondere aufgrund des Einsatzes in potentiell explosionsgefährdeten Umgebungen vorteilhaft, da in diesen Umgebungen die Energie selbst kleiner Funken ausreichen kann, um eine Explosion auszulösen. Darüber hinaus haben BLDC-Motoren den Vorteil, dass die Induktivität sehr viel geringer ist als bei einem herkömmlichen Bürstenmotor. Der Einsatz des BLDC-Motors ermöglicht in der gesamten Elektronik den Einsatz höherer Spannungen und es dürfen höhere Ströme fließen als beim Einsatz eines Bürstenmotors. Das bedeutet, dass ein Motor mit hohem Drehmoment bei geringem Stromverbrauch eingesetzt wird.

Optional kann der Schmierstoffspender für eine drahtlose Kommunikation ausgebildet sein. Dazu kann die Schaltungsanordnung mit einem Kommunikationsmodul, z. B. einem Funkmodul, ausgerüstet sein, welches z. B. auf der Hauptplatine (z. B. als separate Schaltungsinsel) angeordnet ist. Die Möglichkeit der drahtlosen Kommunikation, z. B. per Funk, ist insbesondere in explosionsgefährdeten Bereichen vorteilhaft, da die Schmierstellen, an denen die Schmierstoffspender eingesetzt werden, häufig nur schwer zu erreichen sind und häufig auch besondere Anforderungen an die Arbeitssicherheit bestehen. Als Funkprotokolle kommt z. B. ein Bluetooth-Protokoll in Betracht, d. h. das Funkmodul kann als Bluetooth-Modul, z. B. als Bluetooth-Low-Energy-Modul (BLE) ausgebildet sein. Alternativ kommen aber auch andere Funkmodule bzw. andere Übertragungsprotokolle in Betracht, z.B. WLAN, LPWAN (z. B. LoRa, SigFox). Über die drahtlose Kommunikation besteht die Möglichkeit, die Schmierstoffspender zu warten, Informationen abzufragen oder gegebenenfalls auch Einstellungen vorzunehmen. Die Schmierstoffspender können zwar mit einem Display und mit Einstellmöglichkeiten am Schmierstoffspender ausgerüstet sein. Zusätzlich kann es jedoch vorteilhaft sein, die Informationen auch auf ein geeignetes Endgerät, z. B. ein Smartphone, Tablett oder einen Computer zu übertragen, sodass von dort Informationen abgelesen und gegebenenfalls auch Einstellungen am Schmierstoffspender verändert werden können. Dabei kann auf kabelgebundene Verbindungen verzichtet werden, die insbesondere in explosionsgefährdeten Bereichen problematisch sind. Der batteriebetriebene Schmierstoffspender mit drahtloser Kommunikation hat den Vorteil, dass nicht in die Energieversorgung der Anlage eingegriffen werden muss. Drahtlos kann der Anwender diverse Informationen vom Schmiersystem aus sicherer Entfernung, z. B. mit einem explosions-geschützten Smartphone abfragen. Umgekehrt kann das Personal auch drahtlos Informationen an das Schmiersystem schicken, z. B. Störungen quittieren oder Sonderspenden auslösen. Mit Hilfe von Gateways kann optional die Möglichkeit realisiert werden, dass das Personal nicht in der Nähe der Schmierstelle sein muss, d. h. die Kommunikation ist auch über die Bluetooth-Reichweite hinaus möglich. Informationen können auch direkt von der Leitwarte der Anlage abgefragt werden.

In bevorzugter Ausführungsform wird die Schaltungsanordnung, z. B. die Hauptplatine, mit einem Kommunikations-Modul bestückt, welches einerseits an den Mikrocontroller und andererseits an die geregelte Batteriespannung bzw. die Betriebsspannung angeschlossen ist. Auch ein solches Kommunikations-Modul, z. B. Bluetooth-Modul, kann als separate Schaltungsinsel realisiert sein. In diesem Fall ist eine Leistungsbegrenzung über einen Vorwiderstand eventuell nicht möglich, da das Modul für eine entsprechende Sendeleistung einen verhältnismäßig hohen Strom benötigt, d. h. das Modul ist nicht leistungsbegrenzbar. In diesem Fall kann es zweckmäßig sein, eine solche Schaltungsinsel mit einer zusätzlichen, eigenen Sicherung, z. B. einer Temperatursicherung auszurüsten, die bei einer bestimmten Auslösetemperatur auslöst. Es lassen sich folglich auch Schutzinseln realisieren, die nicht über einen Vorwiderstand leistungsbegrenzt sind, sondern die jeweils mit eigenen Sicherungsmechanismen, z. B. Temperatursicherungen ausgerüstet sind.

Ähnliches gilt z. B. für eine Schutzinsel, welche die Motorschaltung aufnimmt. Im Falle des Motors ist eine Leistungsbegrenzung über einen Vorwiderstand ggf. nicht möglich. Es muss jedoch gewährleistet sein, dass die Energie, die in den Spulen des Motors gespeichert wird, begrenzt wird. Dieses gelingt über die beschriebene Strombegrenzung. Die Leistungsbegrenzung über einen Vorwiderstand ist bei einem Motor, z. B. BLDC-Motor, z. B. deshalb nicht möglich, da durch den hohen Strom des Motors an einem Vorwiderstand ein so großer Spannungsabfall entstehen würde, dass die verbleibende Restspannung für den korrekten Betrieb des Motors nicht mehr ausreichen würde. Es kann im Übrigen zweckmäßig sein, einen BLDC-Motor ohne Hall-Sensoren zur Bestimmung der Position des Rotors einzusetzen, da Hall-Sensoren in einem niedrigen Spannungsbereich gegebenenfalls nicht betrieben werden können. Die Verwendung von Motoren mit Hall-Sensoren ist erst bei höheren Spannungen möglich. Bei der Ansteuerung eines BLDC-Motors ohne Hall-Sensoren sind bestimmte Bedingungen bzw. Vorgaben zu berücksichtigen. So könnte die Ansteuerung entweder direkt über den Mikrocontroller (mit einer nachgeschalteten Treiberstufe) erfolgen, d. h. die Ansteuerung ist dann über Software geregelt. Alternativ wird ein entsprechender BLDC-Motorcontroller eingesetzt. Dieser Motorcontroller erhält vom Mikrocontroller ein PWM-Signal zur Geschwindigkeitsvorgabe. Die Ansteuerung des Motors inklusive Treiberstufe ist vorzugsweise vollständig im Motorcontroller integriert. Der Motorcontroller gibt zur Überwachung der Anzahl der Umdrehungen des Motors durch den Mikrocontroller ein Drehzahlsignal an den Mikrocontroller. Der Motorcontroller selbst kann wiederum über einen Vorwiderstand leistungsbegrenzt werden. Alternativ besteht aber auch die Möglichkeit, den Motorcontroller über eine Temperatursicherung gegen zu hohe Erwärmung zu schützen, sodass in diesem Fall auf einen leistungsbegrenzenden Widerstand verzichtet werden kann.

Insgesamt wird durch die erfindungsgemäßen Maßnahmen ein Schmierstoffspender zur Verfügung gestellt, der einerseits mit einem elektromechanischen Antrieb ausgerüstet ist und der andererseits für den Einsatz in potentiell explosionsgefährdeten Umgebungen einsetzbar ist. Durch die beschriebenen Maßnahmen werden Spannungen und Stromstärken, die auf einer Platine fließen, begrenzt. Temperaturerhöhungen werden begrenzt bzw. vermieden. Funken werden vermieden bzw. die Funkenenergie wird begrenzt. Sollten Fehler auftreten, sind die ex-relevanten Schaltungsbereiche bevorzugt mehrfach bevorzugt dreifach-redundant mit Schutzmechanismen ausgerüstet.

Je nach Auslegung lässt sich durch die erfindungsgemäßen Maßnahmen eine Ex-Schutz-Zertifizierung für das gewünschte Niveau, z. B für die Gasgruppe IIB oder auch IIC erreichen.

Im Übrigen betrifft die Erfindung auch eine Steuerplatinenanordnung der beschriebenen Art, die für den beschriebenen Schmierstoffspender in der beschriebenen Weise eingerichtet ist. Die Steuerplatinenanordnung, die bevorzugt aus Hauptplatine und Zusatzplatine besteht und bei der es besonders darauf ankommt, dass mehrere, separate Schaltungsinseln als Ex-Schutzinseln ausgebildet sind, wird folglich auch selbstständig unter Schutz gestellt.

Im Folgenden wird die Erfindung anhand von Zeichnungen näher erläutert, welche lediglich ein Ausführungsbeispiel darstellen. Es zeigen:

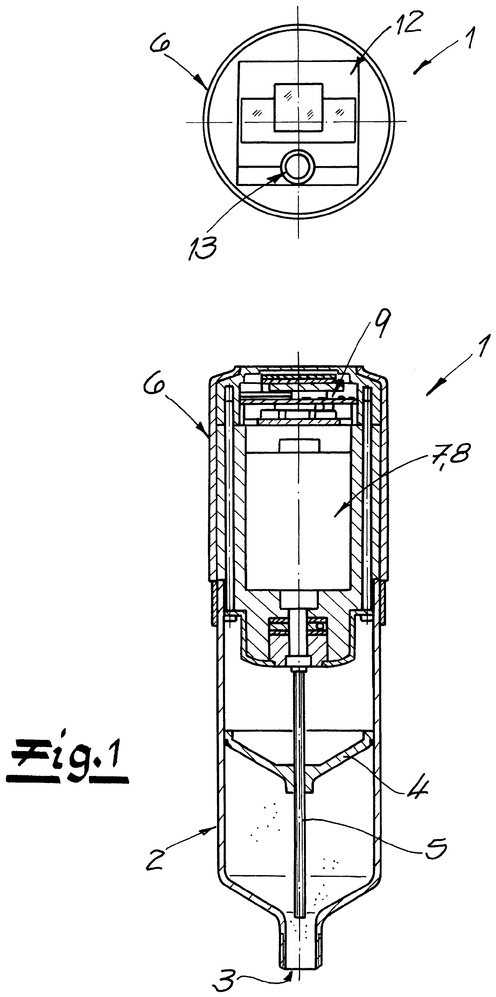

- Fig. 1: einen Schmierstoffspender in einer vereinfachten Darstellung,
- Fig. 2: ein Blockdiagramm einer Schaltungsanordnung des Schmierstoffspenders nach Fig. 1,
- Fig. 3: ein Blockdiagramm einer Zusatzplatine der Schaltungsanordnung nach Fig. 2,
- Fig. 4: die Spannungsregler der Zusatzplatine nach Fig. 3,
- Fig. 5: eine alternative Ausgestaltung der Zusatzplatine nach Fig. 3 mit vereinfachter Strombegrenzung,
- Fig. 6: eine alternative Ausführungsform einer Schaltungsanordnung nach Fig. 2
- Fig. 7: eine alternative Ausführungsform der Spannungsregeleinrichtung auf der Zusatzplatine.

In den Figuren ist ein Schmierstoffspender 1 dargestellt, der für den Einsatz in potentiell explosionsgefährdeten Bereichen vorgesehen ist. Der Schmierstoffspender 1 dient der automatisierten Schmierung von z. B. Maschinen- und Anlagenteilen und kann bevorzugt für eine Einzelpunktschmierung verwendet werden. Grundsätzlich ist aber auch der Einsatz für eine Mehrpunktschmierung möglich. Zum grundsätzlichen Aufbau des in den Figuren beispielhaft dargestellten Schmierstoffspenders 1 gehören ein Schmierstoffvorrat 2 in der Ausführungsform als Schmierstoffkartusche 2, die mit Schmierstoff gefüllt ist und eine Auslassöffnung 3 für den Schmierstoff aufweist. In der Kartusche 2 ist ein Betätigungselement 4 in der Ausführungsform als Kolben 4 zum Herausdrücken des Schmierstoffs aus der Auslassöffnung 3 angeordnet. Dieser Kolben 4 ist an einer drehbaren Spindel 5 angeordnet. Die Schmierstoffkartusche 2 ist mit einem in einem Gehäuse 6 angeordneten Antrieb 7 verbunden, wobei dieser Antrieb 7 als elektromechanischer Antrieb ausgebildet ist. Im Ausführungsbeispiel handelt es sich um einen elektromotorischen Antrieb bzw. einen Elektromotor 7, insbesondere einen Gleichstrommotor, der vorzugsweise als bürstenloser Gleichstrommotor ausgebildet ist. Der Motor 7 treibt die Spindel 5 an, über die der Schmierstoff aus der Kartusche 2 gedrückt wird.

Zur Energieversorgung des Schmierstoffspenders 1 ist eine Batterie 8 bzw. eine Batterieanordnung mit mehreren Batterien 8 vorgesehen, die eine Gleichspannung als Batteriespannung V_{B} (z. B. 4,5 V) zur Verfügung stellt. Ferner ist eine Steuerplatinenanordnung 9 vorgesehen, die ebenfalls in dem Gehäuse 6 angeordnet ist. Diese Steuerplatinenanordnung 9 weist eine elektronische Schaltungsanordnung mit zumindest einem zentralen Mikrocontroller 10 und zusätzlichen elektronischen Funktionsbauteilen sowie Leiterbahnen 11 auf. Die Steuerplatinenanordnung 9 ist einerseits mit der Batterie 8 und andererseits mit dem Antrieb 7 verbunden. Die Steuerplatinenanordnung 9 ist für die Steuerung des Antriebes 7 und damit für die Steuerung des Schmierstoffspenders 1 eingerichtet. Dazu ist der Schmierstoffspender 1 mit verschiedenen elektronischen Bauteilen ausgestattet, die auf der Steuerplatinenanordnung angeordnet oder mit dieser verbunden sind. Insbesondere können eine Anzeigevorrichtung 12 und/oder Einstellmöglichkeiten 13, z. B. Einstelltaster oder dergleichen vorgesehen sein, um Änderungen an der Konfiguration des Schmierstoffspenders 1 vorzunehmen und/oder ablesen zu können, z. B. Spendeintervalle oder dergleichen. Ferner kann die Steuerplatinenanordnung mit Sensoren, z. B. einem Temperatursensor ausgerüstet oder verbunden sein.

Die Steuerplatinenanordnung 9 ist erfindungsgemäß für den Betrieb des Schmierstoffspenders in potentiell explosionsgefährdeten Umgebungen ausgebildet, und zwar vorzugsweise für Umgebungen der "Zone 0". Dazu sind Spannungen und Stromstärken, die auf der Platinenanordnung fließen, begrenzt. Es müssen Temperaturerhöhungen begrenzt bzw. vermieden werden und außerdem müssen Funken vermieden werden bzw. die Funkenenergie begrenzt werden.

Dazu ist erfindungsgemäß vorgesehen, dass die elektronische Schaltungsanordnung in mehrere Schaltungsinseln E1 bis E9 aufgeteilt ist, die auch als Ex-Schutz-Inseln bezeichnet werden. Zumindest einige dieser Schaltungsinseln sind jeweils (separat) leistungsbegrenzt, z. B. durch leistungsbegrenzende Widerstände, z. B. Vorwiderstände R1, R1', R2, R3.

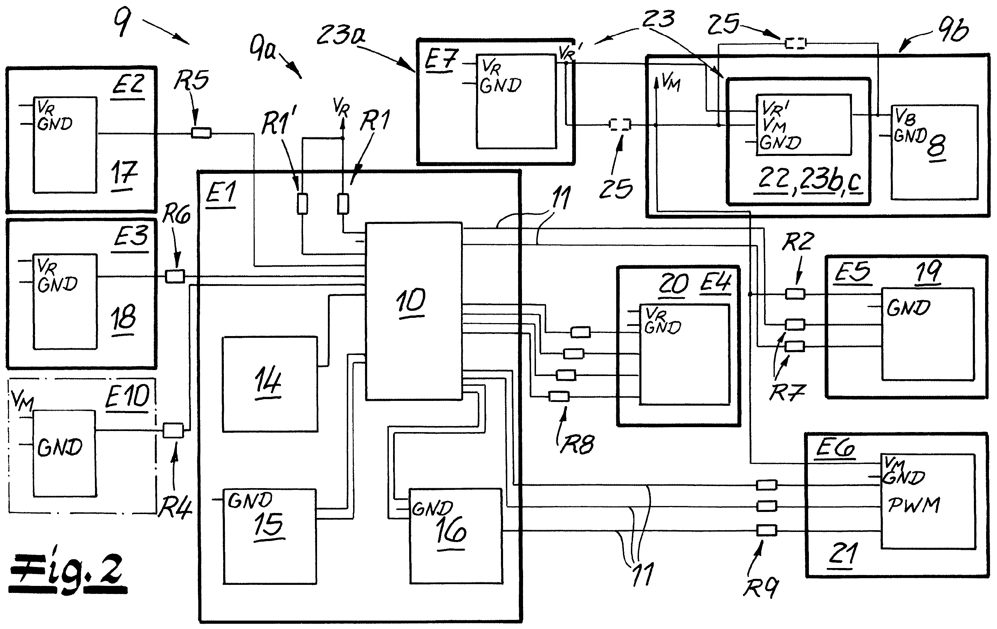

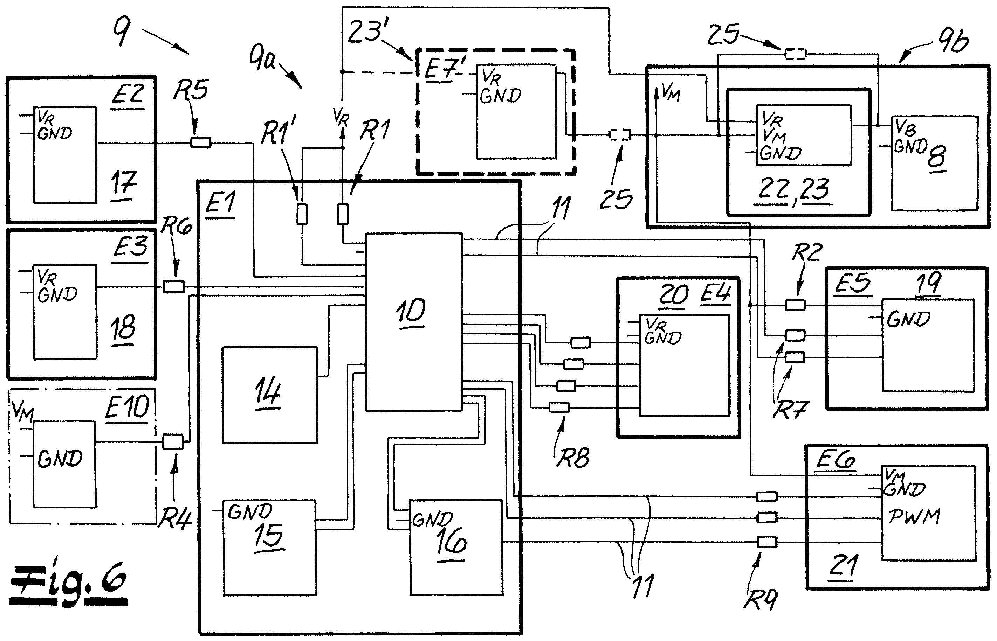

In Fig. 2 bzw. 6 ist die Schaltungsanordnung dargestellt und es ist erkennbar, dass eine Vielzahl von Schutzinseln gebildet sind, die z. B. mit E1 bis E7 sowie E10 bezeichnet sind.

Eine Ex-Schutz-Insel E1 umfasst den Mikrocontroller 10 sowie als zusätzliche Funktionsbauteile z. B. eine optische Anzeige, z. B. LCD-Anzeige 14, einen Temperatursensor 15 und/oder eine Filtereinheit 16, zur Filterung bzw. Glättung des Motorstroms. Als weitere, separate Schaltungsinseln E2 - E6 sind z. B. eine Beleuchtung 17 für die (LCD-) Anzeige, ein Funkmodul, z. B. Bluetooth-Modul 18, eine LED-Anordnung 20, ein Schaltungsteil 19 zur Messung der Batteriespannung, sowie eine Motorsteuerung bzw. die Motoranschlusseinrichtung 21 vorgesehen.

Von besonderer Bedeutung ist, dass die Schaltungsinseln, die mit der Batterie verbunden sind beziehungsweise mit der Batteriespannung versorgt werden, so ausgebildet sind, dass die innerhalb der jeweiligen Schaltungsinsel maximal mögliche Leistung jeweils begrenzt ist, und zwar z. B. durch jeweils einen leistungsbegrenzenden Widerstand, z. B. Vorwiderstand. Schaltungsinseln ohne Leistungsbegrenzung können mit einer Temperatursicherung ausgerüstet sein. Darauf wird im Folgenden noch eingegangen.

Von besonderer Bedeutung ist außerdem, dass die erfindungsgemäße Schaltungsanordnung mit einer Strombegrenzungseinrichtung 22 versehen ist, die die Gesamtenergie innerhalb der Schaltungsanordnung insgesamt begrenzt. Außerdem ist die Schaltungsanordnung mit einer Spannungsregeleinrichtung 23 versehen, welche die Batteriespannung V_{B} auf eine geregelte Betriebsspannung V_{R} reduziert.

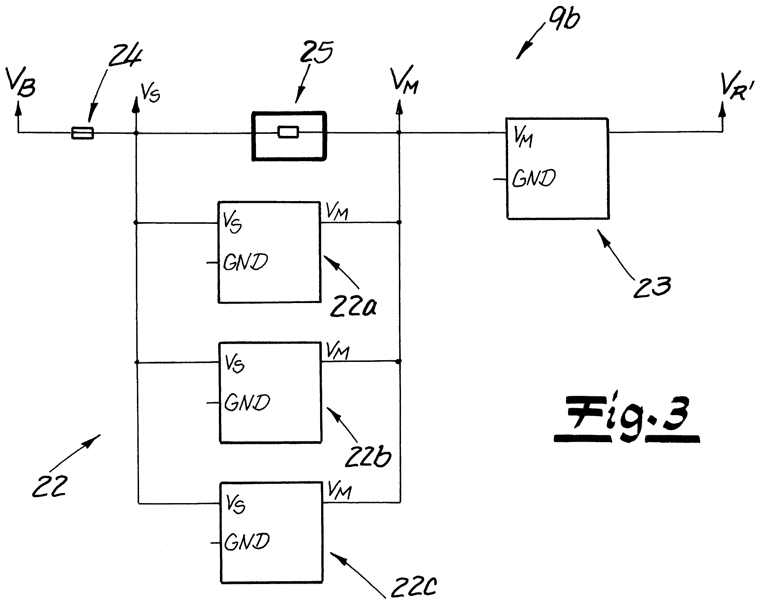

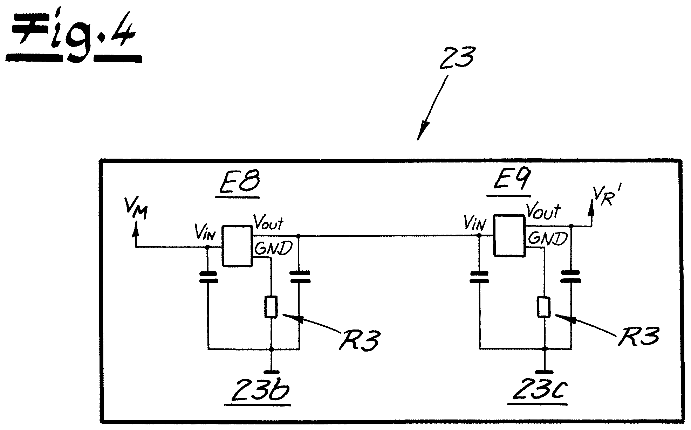

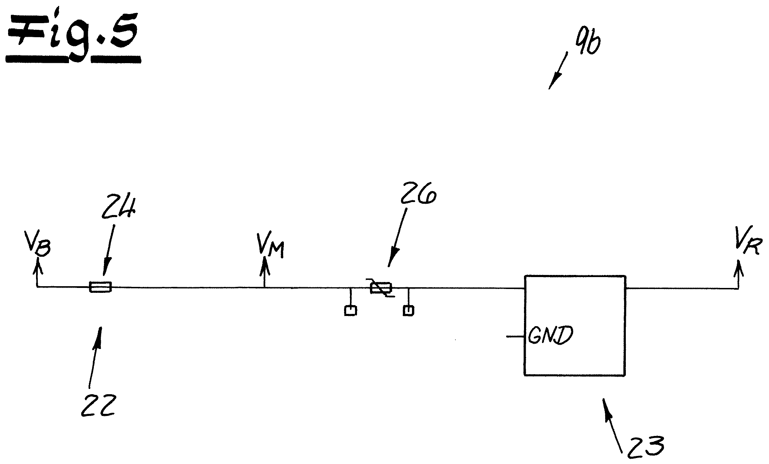

In den dargestellten Ausführungsbeispielen weist die Schaltungsanordnung einerseits eine Hauptplatine 9a und andererseits eine auf der Hauptplatine 9a angeordnet Zusatzplatine 9b auf, die in Fig. 2 bzw. 6 oben rechts angedeutet und in Fig. 3 bzw. 5 dargestellt ist. Die Zusatzplatine 9b nimmt insbesondere die Strombegrenzungseinrichtung 22 auf, die optional gem. Fig. 3 mehrfach redundant ausgebildet sein kann und dazu drei Strombegrenzer 22a, b, c umfasst, die parallel geschaltet sind. Auch die Spannungsregeleinrichtung 23 ist mehrfach redundant ausgebildet. Dazu weist sie drei Spannungsregler 23a, b, c auf, die in Reihe geschaltet sind. Dabei zeigt eine vergleichende Betrachtung der Figuren 2 und 4, dass von diesen drei Spannungsreglern (in der Ausführungsform nach Fig. 2 bzw. 4) ein Spannungsregler 23a auf der Hauptplatine 9a angeordnet ist, während zwei weitere Spannungsregler 23b, c auf der Zusatzplatine 9b angeordnet sind. Dabei bilden der Spannungsregler 22a auf der Hauptplatine 9a und die Spannungsregler 23b, 23c auf der Zusatzplatine 9b jeweils eine eigene Ex-Schutz-Insel E7, E8, E9.

In Fig. 3 bzw. 5 ist erkennbar, dass an die Strombegrenzungseinrichtung 22 und Spannungsregeleinrichtung 23 die Batteriespannung V_{B} von z. B. 4,5 V angeschlossen ist. Über die Spannungsregeleinrichtung 23 wird diese Batteriespannung auf die geregelte Betriebsspannung V_{R'} bzw. V_{R} von z. B. 3,3 V reduziert. In der Schaltungsanordnung finden sich folglich drei Spannungsangaben, zum einen die Ausgangsspannung V_{B} der Batterie von 4,5 V, die hinter den Strombegrenzungseinrichtungen und einer zusätzlichen Schmelzsicherung angeordnete, zum anderen die nicht reduzierte Hauptspannung V_{M} von ebenfalls 4,5 V und schließlich die reduzierte, geregelte Betriebsspannung V_{R'} bzw. V_{R} von 3,3 V. Außerdem ist die über dem Shunt-Widerstand 25 abfallende Spannung Vₛ dargestellt.

In Fig. 2 ist erkennbar, dass die von der Zusatzplatine 9b gelieferte, reduzierte Betriebsspannung V_{R'} noch über den dritten Spannungsregler 23a geführt wird, an dessen Ausgang die für die elektronische Schaltung relevante, reduzierte Betriebsspannung V_{R} zur Verfügung steht. Diese versorgt gemäß Fig. 2 z. B. die Ex-Schutz-Insel mit dem Mikrocontroller und der LCD Beleuchtung. Dabei ist erkennbar, dass diese Ex-Schutz-Inseln, die mit der reduzierten Batteriespannung verbunden sind, über Widerstände R1, R1', R2, R3 leistungsbegrenzt sind. So ist die Ex-Schutz-Insel E1 des Mikrocontrollers 10 über zumindest einen leistungsbegrenzenden Vorwiderstand, z. B. den Vorwiderstand R1, leistungsbegrenzt sein. In dem in Fig. 2 bzw. 6 dargestellten Ausführungsbeispiel wird der Mikrocontroller über zwei leistungsbegrenzende Vorwiderstände R1, R1' an die reduzierte, geregelte Betriebsspannung V_{R} angeschlossen. Dabei versorgt einer der Anschlüsse die Digitalteile des Mikrocontrollers 10 und der andere die Analogteile, z. B. den Analog-DigitalWandler, mit der Spannung. Innerhalb der Ex-Schutz-Insel E1 des Mikrocontrollers 10 sind die dort außerdem vorgesehenen Funktionsbauteile nicht unmittelbar mit der Betriebsspannung verbunden, sondern lediglich mit dem Mikrocontroller 10, sodass diese Funktionsbauteile nicht separat über Vorwiderstände leistungsbegrenzt sein müssen. Ferner ist erkennbar, dass z. B. die Ex-Schutz-Insel E5 über den Vorwiderstand R2 leistungsbegrenzt ist. Auch die Ex-Schutz-Inseln E2, E4 und E10 sind leistungsbegrenzt, und zwar jeweils über einen Vorwiderstand, der in den Figuren nicht dargestellt ist.

Auch die Spannungsregler 23a, b, c selbst sind über Widerstände R3 leistungsbegrenzt, sodass auch die beiden auf der Zusatzplatine 9b angeordneten Spannungsregler 23b, c sowie der auf der Hauptplatine 9a angeordnete Spannungsregler 23a jeweils eine separate Ex-Schutz-Insel E7, E8, E9 bilden.

Bei den erwähnten Widerständen R1, R1', R2 und R3 handelt es sich um Vorwiderstände, die die jeweils zugeordnete Schaltungsinsel leistungsbegrenzen. Ferner sind in den Zeichnungen die Widerstände R4, R5, R6, R7, R8 und R9 dargestellt, bei denen es sich nicht um leistungsbegrenzende Vorwiderstände handelt, sondern um Widerstände, die zwischen den einzelnen Ex-Schutz-Inseln angeordnet sind und auf diese Weise eine Leistungsbegrenzung zwischen den miteinander verbundenen Ex-Schutz-Inseln realisieren. Dieses dient im dargestellten Ausführungsbeispiel insbesondere dem Schutz der zentralen Ex-Schutz-Insel E1 bzw. dem Schutz des Mikrocontrollers 10, denn die übrigen Ex-Schutz-Inseln sind über die Widerstände R4, R5, R6, R7, R8 und R9 mit dieser Ex-Schutz-Insel E1 verbunden. Dabei sind schematisch vereinfacht in einigen Verbindungen lediglich ein einzelner Zwischenwiderstand R4, R5 bzw. R6 eingezeichnet und in einige Verbindungen sind beispielhaft Gruppen von Zwischenwiderständen R7, R8 und R9 eingezeichnet, da dort auch mehrere Verbindungsleitungen zwischen den Ex-Schutz-Inseln eingezeichnet sind.

Ferner ist in Fig. 3 bzw. 5 erkennbar, dass die Strombegrenzungseinrichtung 22 zusätzlich eine Schmelzsicherung 24 umfasst.

In Fig. 5 ist eine alternative Ausführungsform für die Strombegrenzung 22 dargestellt, die alternativ auch im Zusammenhang mit Fig. 2 oder auch Fig. 6 eingesetzt werden kann. Fig. 5 zeigt wiederum vereinfacht die Zusatzplatine 9b mit der Spannungsregeleinrichtung 23 und einer Strombegrenzungseinrichtung 22, wobei diese Strombegrenzungseinrichtung nicht aktiv ausgestaltet ist und folglich keine aktiven Strombegrenzer aufweist. Stattdessen besteht die Strombegrenzungseinheit 22 lediglich aus einer Schmelzsicherung 24, die den Gesamtstrom begrenzt.

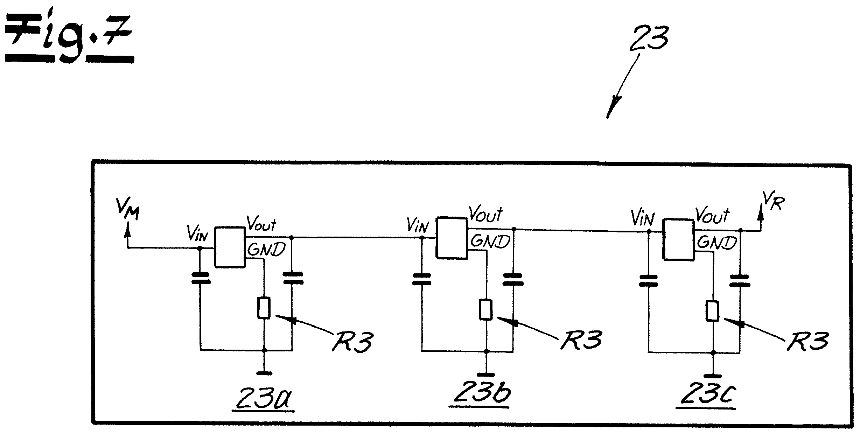

Während Fig. 4 in Verbindung mit Fig. 2 eine Ausführungsform zeigt, bei der lediglich ein Teil der Spannungsbegrenzungseinrichtung 23 auf der Zusatzplatine angeordnet ist, zeigen die Figuren 6 und 7 eine alternative, vorteilhafte Ausführungsform, bei der die gesamte Spannungsbegrenzungseinrichtung 23 mit allen (drei) Spannungsbegrenzern 23a, 23b, 23c auf der Zusatzplatine angeordnet ist. Die in Fig. 6 dargestellte Ausführungsform der Hauptplatine unterscheidet sich von der in Fig. 2 dargestellten Ausführungsform, vor allem dadurch, dass auf der Hauptplatine 9a (im Ex-Schutz Betrieb) kein Spannungsbegrenzer angeordnet ist, da sämtliche Spannungsbegrenzer auf der Zusatzplatine angeordnet sind. Die Hauptplatine gem. Fig. 6 lässt sich folglich mit der Zusatzplatine gem. Fig. 3 ausrüsten, wobei die in Fig. 3 lediglich vereinfacht dargestellte Spannungsregeleinrichtung 23 dann gem. Fig. 7 mit sämtlichen Spannungsbegrenzen 23a, 23b, 23c ausgerüstet ist. Die Zusatzplatine kann auch bei der Ausführungsform der Hauptplatine nach Fig. 6 optional entweder mit der aktiven Strombegrenzung gem. Fig. 3 oder mit der vereinfachten Strombegrenzung über die Schmelzsicherung gem. Fig. 4 realisiert sein.

Dabei ist in Fig. 6 (gestrichelt) angedeutet, dass auch auf der Hauptplatine 9a ein Spannungsregler 23' angeordnet werden kann. Dieses gilt jedoch nur für den Fall, dass die Hauptplatine 9a ohne Zusatzplatine 9b für nicht-Ex-Schutzbereiche eingesetzt werden soll. Die Hauptplatine 9a wird folglich nur in der nicht-Ex-Variante mit einem Spannungsregler 23' bzw. E7` bestückt. In der Ex-Schutz-Variante fehlt der Spannungsregler 23' auf der Hauptplatine 9a gem. Fig. 6, da sämtliche Spannungsregler bei dieser Ausführungsform auf der Zusatzplatine angeordnet sind, so wie in Fig. 7 dargestellt.

Um eventuelle Sonderfunktionen in der Ex-Schutz-Variante der Platine automatisch aktivieren zu können, kann eine Erkennung realisiert sein, die automatisch erkennt, ob die Zusatzplatine aufgelötet ist. Dazu kann ein Pin des Mikrocontrollers 10 mit einem Pull-Up-Widerstand betrieben werden. Durch das Auflöten der Zusatzplatine wird dieser Pin auf Masse gelegt. Somit wird die aufgelötete Zusatzplatine (über die Software, die im Mikrocontroller gespeichert ist) automatisch erkannt.

In Fig. 5 ist im Übrigen angedeutet, dass die Zusatzplatine 9b und insbesondere die Spannungsbegrenzung 23 mit einer Temperatursicherung 26 ausgerüstet sein kann.

Optional ist auf der Hauptplatine ein Funkmodul, z. B. ein Bluetooth-Modul 18 vorgesehen, das ebenfalls als separate Ex-Schutz-Insel E3 ausgebildet sein kann. Dabei ist in Fig. 2 bzw. 5 erkennbar, dass diese Ex-Schutz-Insel E3 bzw. dieses Funk-Modul 18 nicht über einen Vorwiderstand leistungsbegrenzt ist. Da das Modul für eine entsprechende Sendeleistung einen verhältnismäßig hohen Strom benötigt, wird auf eine Leistungsbegrenzung über einen Vorwiderstand verzichtet. Es ist jedoch eine zusätzliche Temperatursicherung in der Ex-Schutz-Insel angeordnet, die bei einer bestimmten Auslösetemperatur auslöst, sodass auf eine Leistungsbegrenzung über einen Vorwiderstand bei dieser Ex-Schutz-Inseln verzichtet werden kann. Die Temperatursicherung ist z. B. mittels eines temperaturleitfähigen Klebers auf der Oberfläche des Funk-Moduls 18 aufgeklebt. Einzelheiten sind nicht dargestellt. Bei dem in der Zeichnung gezeigten Bluetooth-Modul 18 handelt es sich lediglich um eine mögliche Option eines Funkmoduls. Es können auch Funkmodule mit anderem Übertragungsprotokoll zum Einsatz kommen. Im Vordergrund steht die Möglichkeit einer drahtlosen Kommunikation.

Auch die Ex-Schutz-Insel E6 für den Motoranschluss bzw. die Motorsteuerung 21 ist nicht über einen Vorwiderstand leistungsbegrenzt. Auch hier ist eine Temperatursicherung z. B. mittels eines temperaturleitfähigen Klebers auf der Oberfläche der Platine bzw. des Platinenabschnitts aufgeklebt. Dabei wird z. B. ein BLDC-Motor ohne Hall-Sensoren zur Bestimmung der Position des Rotors verwendet, da ein solcher Motor ohne Hall-Sensoren mit niedrigen Spannungen arbeiten kann. Die Ansteuerung erfolgt über einen BLDC-Motorcontroller. Dieser Motorcontroller 21 erhält vom Mikrocontroller 10 ein PWM-Signal zur Geschwindigkeitsvorgabe. Die Ansteuerung des Motors inklusive Treiberstufe ist vollständig in den Motorcontroller 21 integriert. Der Motorcontroller 21 selbst ist in der beschriebenen Weise mit einer Temperatursicherung gegen zu hohe Erwärmung geschützt. Im Übrigen ist gewährleistet, dass die Energie, die in den Spulen des Motors gespeichert wird, begrenzt wird, um Temperaturerhöhungen und Funkenbildungen zu vermeiden. Dieses gelingt über die beschriebene Strombegrenzung, die auf der Zusatzplatine ausgerüstet ist, sodass für diese Ex-Schutz-Insel keine Leistungsbegrenzung über einen zusätzlichen Vorwiderstand erforderlich ist.

Die im Ausführungsbeispiel auf der Zusatzplatine 9b realisierte Strombegrenzung 22 begrenzt an zentraler Stelle den Strom der gesamten Schaltung 9.

Dadurch müssen in den übrigen bzw. einzelnen Schaltungsteilen oder Ex-Schutz-Inseln keinerlei strombegrenzende Maßnahmen mehr realisiert werden. Die leistungsbegrenzenden Widerstände R1, R1', R2, R3 der Ex-Schutz-Inseln dienen unabhängig von der Strombegrenzung dazu, dass im Fehlerfall eines integrierten Bausteins, z. B. bei einem Kurzschluss, der im Baustein entstehen könnte, dieser Baustein nicht über seine Maximalleistung belastet wird. Grundsätzlich könnte auch in der Zuleitung zu den leistungsbegrenzenden Widerständen ein Fehler entstehen, indem dort ein Kurzschluss nach Masse auftritt. Grundsätzlich könnte man diesen Fehler durch entsprechende Abstände der Leiterbahnen gegenüber Masse vermeiden, d. h. durch eine sogenannte "Nicht-Störanfälligkeit der Leiterbahn gegen Kurzschluss". Durch den Einsatz der zentralen Strombegrenzung ist es aber nicht mehr erforderlich, diese Maßnahmen vorzunehmen.

Von besonderer Bedeutung sind im Zusammenhang mit Schaltungsanordnungen für explosionsgefährdete Bereiche die Abstände von Bauteilen und Leiterbahnen, die bestimmte Mindestabstände nicht unterschreiten dürfen, um Kurzschlüsse zu vermeiden, die sich z. B. durch leitfähige Staubpartikel bilden können. In diesem Zusammenhang ist die Ausgestaltung der Schaltungsanordnung mit mehreren separaten Schaltungsinseln besonders vorteilhaft, denn innerhalb der Schaltungsinseln können kleinere Abstände realisiert werden als zwischen den Schaltungsinseln. Erfindungsgemäß ist folglich vorgesehen, dass die Abstände der Leiterbahnen zwischen einzelnen Schaltungsinseln einen vorgegebenen Mindestabstand nicht unterschreiten, wobei dieser Mindestabstand größer ist als der Abstand der Leiterbahnen innerhalb der Schaltungsinseln. Eine weitere Verbesserung kann optional - je nach angestrebten Schutzniveau - dadurch erreicht werden, dass die Schaltungsanordnung zumindest bereichsweise mit einer elektrisch isolierenden Schutzbeschichtung versehen ist, da sich durch solche Schutzbeschichtungen die zulässigen Abstände zwischen den Leiterbahnen weiter verringern lassen. Im Bereich der Hauptplatine kann gegebenenfalls ein Schutzlack verwendet werden, d. h. die Schaltungsanordnung auf der Hauptplatine kann bereichsweise mit einem Schutzlack überzogen sein. Dabei werden z. B. bestimmte Bereiche ausgespart, d. h. in bestimmten Bereichen wird auf einen Schutzlack verzichtet, da der Schutzlack bei bestimmten Komponenten zu Beeinträchtigungen führen kann oder in bestimmten Bereichen räumlich die Aufbringung eines Schutzlackes nicht möglich ist. Es ist jedoch auch möglich, auf der Hauptplatine vollständig auf einen Schutzlack zu verzichten.

Auf der Hauptplatine bzw. in Bereichen der Hauptplatine, in denen kein Schutzlack vorgesehen ist, wird z. B. ein vorgegebener erster Mindestabstand von z. B. 1,5 mm nicht unterschritten. Dabei handelt es sich z. B. um die Bereiche zwischen einzelnen Schaltungsinseln, die ohne Schutzlack frei liegen.

In den Bereichen zwischen einzelnen Schaltungsinseln, die mit einer Schutzbeschichtung versehen sind, wird ein zweiter Mindestabstand von z. B. 0,5 mm eingehalten.

Innerhalb der Schaltungsinseln lässt sich der Mindestabstand weiter reduzieren, sodass innerhalb der Schaltungsinseln ein dritter Mindestabstand von zum Beispiel 0,2 mm eingehalten wird, und zwar unabhängig davon, ob eine Schutzbeschichtung vorgesehen ist oder nicht.

Die gesamte Sicherheit wird noch dadurch erhöht, dass die Zusatzplatine 9b teilweise oder vollständig mit einer Schutzbeschichtung versehen bzw. ummantelt ist, z. B. in eine Schutzbeschichtung eingegossen ist. So kann es zweckmäßig sein, die Zusatzplatine lediglich auf einer Seite zu vergießen. Dieses ist in den Zeichnungen nicht dargestellt.

In dem dargestellten Ausführungsbeispiel mit Hauptplatine 9a und Zusatzplatine 9b ist im Übrigen vorteilhaft, dass die Schaltungsanordnung auch ohne die Zusatzplatine eingesetzt werden kann, und zwar für Anwendungen außerhalb von explosionsgefährdeten Bereichen. In diesem Fall wird auf die Strombegrenzungseinrichtung verzichtet. Auf der Hauptplatine ist dennoch ein einzelner Spannungsregler vorgesehen, der folglich nicht mehr mehrfachredundant ausgebildet sein muss. Die Schaltungsanordnung nach Fig. 2 funktioniert folglich auch ohne die Zusatzplatine, wobei in diesem Fall die in Fig. 2 dargestellten Brücken 25 bestückt werden müssen. Bei der Schaltungsanordnung nach Fig. 6 wird für die Anwendung außerhalb von explosionsgefährdeten Bereichen ein Spannungsbegrenzer 23' vorgesehen, der in der Ex-Schutzvariante nicht auf der Hauptplatine 9a angeordnet ist, da sämtliche Spannungsbegrenzer bei dieser Ausführungsform nach Fig. 6 und 7 auf der Zusatzplatine angeordnet sind. Auch in diesem Fall werden die in Fig. 6 dargestellten Brücken 25 bestückt.

Im Übrigen zeigen sowohl die Ausführungsform nach Fig. 2 als auch die Ausführungsform nach Fig. 6 einen optional realisierbaren zusätzlichen Block, bzw. eine zusätzliche Schaltungsinsel E10, der einer Batterieunterscheidung dient. Mit dieser Schaltungsinsel, die über einen nicht dargestellten Widerstand leistungsbegrenzt ist, wird das Batteriepack kontrolliert mit einem bestimmten Strom belastet, und zwar mit der Belastung durch die Ansteuerung des Motors und der LEDs. Über den technologiebedingten Spannungseinbruch kann dadurch ermittelt werden, welcher Batterietyp eingelegt ist, z. B. ob eine Alkali- oder eine Lithiumbatterie bzw. -batteriepack eingelegt ist. Über den Widerstand R4 erfolgt die bereits erwähnte Leistungsbegrenzung zwischen der Schutzinsel E10 und der Schutzinsel E1.

## Patentansprüche

1. Schmierstoffspender (1) mit zumindest
- einem Schmierstoffvorrat (2),
- einem elektromechanischen Antrieb (7) , der auf zumindest ein Betätigungselement (4) zum Ausstoßen von Schmierstoff aus dem Schmierstoffvorrat (2) arbeitet,
- einer Batterie (8), welche eine Batteriespannung (V_{B}) zur Verfügung stellt,
- einer Steuerplatinenanordnung (9), die zumindest eine Hauptplatine (9a) mit einer elektronischen Schaltungsanordnung mit zumindest einem zentralen Mikrocontroller (10) und zusätzlichen elektronischen Funktionsbauteilen sowie Leiterbahnen (11) aufweist,
**dadurch gekennzeichnet, dass**
die elektronische Schaltungsanordnung in mehrere Schaltungsinseln (E1 bis E9) aufgeteilt ist oder mehrere Schaltungsinseln (E1 bis E9) aufweist, wobei einige oder sämtliche Schaltungsinseln jeweils leistungsbegrenzt sind und
, dass eine oder mehrere der Schaltungsinseln durch jeweils zumindest einen leistungsbegrenzenden Widerstand (R1, R1', R2, R3), leistungsbegrenzt sind.

2. Schmierstoffspender nach Anspruch 1, **dadurch gekennzeichnet, dass** der jeweils leistungsbegrenzende Widerstand (R1, R1' R2, R3') ein Vorwiderstand ist.

3. Schmierstoffspender nach Anspruch 1 oder 2, **dadurch gekennzeichnet, dass** eine oder mehrere Schaltungsinseln, vorzugsweise solche ohne Leistungsbegrenzung, jeweils mit einer Temperatursicherung ausgerüstet sind, die z. B. auf der Platine im Bereich der Schaltungsinsel befestigt ist, z. B. aufgeklebt ist.

4. Schmierstoffspender nach einem der Ansprüche 1bis 3, **dadurch gekennzeichnet, dass** der elektromechanische Antrieb (7) als Gleichstrommotor, vorzugsweise als bürstenloser Gleichstrommotor (BLDC) ausgebildet ist oder einen solchen umfasst.

5. Schmierstoffspender nach einem der Ansprüche 1 bis 4, **dadurch gekennzeichnet, dass** die Abstände der Leiterbahnen (11) zwischen einzelnen Schaltungsinseln einen vorgegebenen Mindestabstand nicht unterschreiten, wobei vorzugsweise dieser Mindestabstand größer ist als der Abstand der Leiterbahnen innerhalb einer Schaltungsinsel bzw. innerhalb der Schaltungsinseln.

6. Schmierstoffspender nach einem der Ansprüche 1 bis 5, **dadurch gekennzeichnet, dass** die Schaltungsanordnung mit einer Strombegrenzungseinrichtung (22) versehen ist oder verbunden ist, die die Gesamtenergie innerhalb der (gesamten) Schaltungsanordnung begrenzt.

7. Schmierstoffspender nach Anspruch 6, **dadurch gekennzeichnet, dass** die Strombegrenzungseinrichtung (22) mehrfach redundant ausgelegt ist und bevorzugt mehrere, z. B. drei Strombegrenzer umfasst (22a, b, c), die z. B. parallel geschaltet sind.

8. Schmierstoffspender nach Anspruch 6 oder 7, **dadurch gekennzeichnet, dass** die Strombegrenzungseinrichtung (22) (zusätzlich) eine Sicherung (24), z. B. eine Schmelzsicherung, umfasst.

9. Schmierstoffspender nach einem der Ansprüche 1 bis 8, **dadurch gekennzeichnet, dass** die Schaltungsanordnung mit einer Spannungsregeleinrichtung (23) versehen oder verbunden ist, welche die Batteriespannung (V_{B}) auf eine geregelte Betriebsspannung (V_{R}) reduziert.

10. Schmierstoffspender nach Anspruch 9, **dadurch gekennzeichnet, dass** die Spannungsregeleinrichtung (23) mehrfach redundant ausgelegt ist und bevorzugt mehrere, z. B. drei Spannungsregler (23a, b, c) umfasst, die bevorzugt in Reihe geschaltet sind.

11. Schmierstoffspender nach Anspruch 10, **dadurch gekennzeichnet, dass** der oder die Spannungsregler (23a, b, c) jeweils als separate Schaltungsinsel (E7, E8, E9) separat leistungsbegrenzt sind, z. B. durch jeweils einen leistungsbegrenzenden Widerstand (R3).

12. Schmierstoffspender nach einem der Ansprüche 1 bis 11, **dadurch gekennzeichnet, dass** die Steuerplatinenanordnung (9) zusätzlich zu der Hauptplatine (9a) eine damit verbundene Zusatzplatine (9b) umfasst, die z. B. auf die Hauptplatine aufgesetzt ist.

13. Schmierstoffspender nach Anspruch 12, **dadurch gekennzeichnet, dass** die Strombegrenzungseinrichtung (22) auf der Zusatzplatine (9b) angeordnet ist, wobei die Strombegrenzungseinrichtung (22) bevorzugt den in die Hauptplatine (9a) einfließenden Strom begrenzt.

14. Schmierstoffspender nach Anspruch 12 oder 13, **dadurch gekennzeichnet, dass** die Spannungsregeleinrichtung (23) teilweise oder vollständig auf der Hauptplatine angeordnet ist und/oder teilweise oder vollständig auf der Zusatzplatine (9b) angeordnet ist, indem z. B. ein oder mehrere Spannungsregler (23b, c) auf der Zusatzplatine (9b) angeordnet sind.

15. Schmierstoffspender nach Anspruch 14, **dadurch gekennzeichnet, dass** zumindest ein Spannungsregler (23a) auf der Hauptplatine (9a) und ein oder mehrere Spannungsregler (23b, c) auf der Zusatzplatine (9b) angeordnet sind.

16. Schmierstoffspender nach Anspruch 14, **dadurch gekennzeichnet, dass** sämtliche Spannungsregler (23a, 23b, 23c), z.B. alle drei Spannungsregler (23a, 23b, 23c) auf der Zusatzplatine (9b) angeordnet sind.

17. Schmierstoffspender nach einem der Ansprüche 14 bis 16, **dadurch gekennzeichnet, dass** sämtliche Spannungsregler (23a, b, c) auf der Zusatzplatine (9b) mit einer Temperatursicherung ausgerüstet sind, wobei bevorzugt eine gemeinsame Temperatursicherung über sämtliche Spannungsregler auf der Zusatzplatine geklebt ist.

18. Schmierstoffspender nach einem der Ansprüche 1 bis 17, **dadurch gekennzeichnet, dass** die Schaltungsanordnung bereichsweise oder vollständig mit einer elektrisch isolierenden Schutzbeschichtung versehen ist, z. B. mit einem Schutzlack.

19. Schmierstoffspender nach Anspruch 18, **dadurch gekennzeichnet, dass** die Schaltungsanordnung auf der Hauptplatine (9a) bereichsweise mit einer Schutzbeschichtung, z. B. einem Schutzlack überzogen ist.

20. Schmierstoffspender nach Anspruch 17 oder 18, **dadurch gekennzeichnet, dass** die Zusatzplatine (9b) bereichsweise oder vollständig mit einer Schutzbeschichtung versehen ist, z. B. auf einer Seite oder beidseitig teilweise oder vollständig mit einer Schutzbeschichtung ummantelt ist, z. B. in eine Schutzbeschichtung eingegossen oder eingespritzt ist.

21. Schmierstoffspender nach einem der Ansprüche 1 bis 20, **dadurch gekennzeichnet, dass** die Abstände der Leiterbahnen (11)
- zwischen einzelnen Schaltungsinseln ohne eine Schutzbeschichtung einen vorgegebenen ersten Mindestabstand von z. B. 1,5 mm und/oder
- zwischen einzelnen Schaltungsinseln mit einer Schutzbeschichtung einen zweiten Mindestabstand von z. B. 0,5 mm und/oder
- innerhalb einer Schaltungsinsel einen dritten Mindestabstand von z. B. 0,2 mm, z. B. mit oder ohne Schutzbeschichtung,
nicht unterschreiten.

22. Schmierstoffspender nach einem der Ansprüche 1 bis 21, **dadurch gekennzeichnet, dass** der Mikrocontroller (10) gemeinsam mit weiteren Funktionsbauteilen eine gemeinsame (erste) Schaltungsinsel (E1) bildet, wobei die Funktionsbauteile in dieser Schaltungsinsel (E1) nur über den Mikrocontroller mit Spannung versorgt werden.

23. Schmierstoffspender nach einem der Ansprüche 1 bis 22, **dadurch gekennzeichnet, dass** die Schaltungsanordnung in einer Schaltungsinsel (E6), z. B. auf der Hauptplatine, eine mit dem Motor verbundene Motorschaltung (21) umfasst, die an die nicht reduzierte und ungeregelte Batteriespannung (V_{B}) angeschlossen ist, und zwar vorzugsweise ohne leistungsbegrenzenden Widerstand und vorzugsweise mit einer Temperatursicherung.

24. Schmierstoffspender nach einem der Ansprüche 1 bis 23, **dadurch gekennzeichnet, dass** die Schaltungsanordnung in einer Schaltungsinsel (E3), z. B. auf der Hauptplatine, ein Kommunikationsmodul (18) für eine drahtlose Kommunikation umfasst, z. B. ein Kommunikationsmodul für eine Bluetooth-Kommunikation.

25. Schmierstoffspender nach einem der Ansprüche 1 bis 24, **dadurch gekennzeichnet, dass** die Schaltungsanordnung mit einer Platinen-Erkennung ausgerüstet ist, die den Einsatz einer Zusatzplatine erkennt, indem z.B. automatisch erkennbar ist, ob eine Zusatzplatine auf die Hauptplatine aufgesteckt oder aufgelötet ist.

26. Schmierstoffspender nach einem der Ansprüche 1 bis 25, **dadurch gekennzeichnet, dass** zusätzlich zu einer Leistungsbegrenzung einer oder mehrerer Schaltungsinseln zwischen einzelnen, miteinander verbundenen Schaltungsinseln eine Leistungsbegrenzung realisiert ist, z.B. durch einen oder mehrere zwischen zwei Schaltungsinseln angeordnete Widerstände (R4, R5, R6, R7, R8, R9).

27. Steuerplatinenanordnung (9), eingerichtet für einen Schmierstoffspender nach einem der Ansprüche 1 bis 26, wobei die Steuerplatinenanordnung (9) zumindest eine Hauptplatine (9a) mit einer elektronischen Schaltungsanordnung mit zumindest einem zentralen Mikrocontroller (10) und zusätzlichen elektronischen Funktionsbauteilen sowie Leiterbahnen (11) aufweist, **dadurch gekennzeichnet, dass** die elektronische Schaltungsanordnung in mehrere Schaltungsinseln (E1 bis E9) aufgeteilt ist oder mehrere Schaltungsinseln aufweist, wobei einige oder sämtliche Schaltungsinseln jeweils leistungsbegrenzt sind.

## Claims

1. A lubricant dispenser (1) comprising at least
- a lubricant reservoir (2),
- an electromechanical drive (7) that acts on at least one actuating element (4) to dispense lubricant from the lubricant reservoir (2),
- a battery (8) which provides a battery voltage (V_{B}),
- a control board assembly (9) having at least a main board (9a) with an electronic circuit arrangement that comprises at least one central microcontroller (10) and additional electronic functional components, as well as conductor tracks (11),
**characterized in that**
the electronic circuit arrangement is divided into multiple circuit islands (E1 to E9), or comprises multiple circuit islands (E1 to E9), wherein some or all circuit islands are power-limited, and
one or more of the circuit islands are power-limited by at least one power-limiting resistor (R1, R1', R2, R3) .

2. The lubricant dispenser according to Claim 1, **characterized in that** the respective power-limiting resistor (R1, R1', R2, R3) is a series resistor.

3. The lubricant dispenser according to Claim 1 or 2, **characterized in that** one or more circuit islands, preferably those without power limitation, are each equipped with a thermal fuse which is attached to the board in the region of the respective circuit island, for example, e.g. glued in place.

4. The lubricant dispenser according to any one of Claims 1 to 3, **characterized in that** the electromechanical drive (7) is designed as a direct-current motor, preferably as a brushless direct-current motor (BLDC), or comprises such a motor.

5. The lubricant dispenser according to any of Claims 1 to 4, **characterized in that** the spacing of the conductor tracks (11) between individual circuit islands does not fall below a specified minimum distance, wherein this minimum distance is preferably greater than the spacing of conductor tracks within the circuit islands themselves.

6. The lubricant dispenser according to any one of Claims 1 to 5, **characterized in that** the circuit arrangement is provided with, or connected to, a current-limiting device (22) that limits the total energy within the (entire) circuit arrangement.

7. The lubricant dispenser according to Claim 6, **characterized in that** the current-limiting device (22) is designed with multiple redundancies and preferably with multiple, e.g. at least three, current limiters (22a, b, c) which are connected in parallel, for example.

8. The lubricant dispenser according to Claim 6 or 7, **characterized in that** the current-limiting device (22) (additionally) comprises a fuse (24), e.g. a melting fuse.

9. The lubricant dispenser according to any one of Claims 1 to 8, **characterized in that** the circuit arrangement is provided with, or connected to, a voltage regulation device (23) which reduces the battery voltage (V_{B}) to a regulated operating voltage (V_{R}).

10. The lubricant dispenser according to Claim 9, **characterized in that** the voltage regulation device (23) is designed with multiple redundancies and preferably comprises multiple, e.g. three, voltage regulators (23a, b, c) which are connected in series.

11. The lubricant dispenser according to Claim 10, **characterized in that** the voltage regulator or the voltage regulators (23a, b, c) is/are each designed as a separate circuit island (E7, E8, E9) and separately power-limited, e.g. by a power-limiting resistor (R3) in each case.

12. The lubricant dispenser according to any of one of Claims 1 to 11, **characterized in that** the control board assembly (9) comprises, in addition to the main board (9a), an auxiliary board (9b) connected thereto, e.g. mounted on the main board.

13. The lubricant dispenser according to Claim 12, **characterized in that** the current-limiting device (22) is arranged on the auxiliary board (9b), wherein the current-limiting device (22) preferably limits the current flowing into the main board (9a).

14. The lubricant dispenser according to Claim 12 or 13, **characterized in that** the voltage regulation device (23) is partially or fully arranged on the main board and/or partially or fully arranged on the auxiliary board (9b), **in that**, for example, one or multiple voltage regulators (23b, c) are arranged on the auxiliary board (9b).

15. The lubricant dispenser according to Claim 14, **characterized in that** at least one voltage regulator (23a) is arranged on the main board (9a) and one or more voltage regulators (23b, c) is/are arranged on the auxiliary board (9b).

16. The lubricant dispenser according to Claim 14, **characterized in that** all voltage regulators (23a, b, c), e.g. all three voltage regulators (23a, 23b, 23c) are arranged on the auxiliary board (9b).

17. The lubricant dispenser according to any one of Claims 14 to 16, **characterized in that** all voltage regulators (23a, b, c) on the auxiliary board (9b) are equipped with a thermal fuse, wherein preferably a shared thermal fuse is glued to the auxiliary board across all voltage regulators.

18. The lubricant dispenser according to any one of Claims 1 to 17, **characterized in that** the circuit arrangement is partially or fully provided with an electrically insulating protective coating, e.g. with a conformal coating.

19. The lubricant dispenser according to Claim 18, **characterized in that** the circuit arrangement on the main board (9a) is partially coated with a protective coating, e.g. a conformal coating.

20. The lubricant dispenser according to Claim 17 or 18, **characterized in that** the auxiliary board (9b) is partially or fully provided with a protective coating, e.g. is partially or fully encapsulated in a protective coating, e.g. potted or injection-moulded.

21. The lubricant dispenser according to any one of Claims 1 to 20, **characterized in that** the spacing of the conductor tracks (11)
- between individual circuit islands without a protective coating does not fall below a specified first minimum spacing of e.g. 1.5 mm and/or
- between individual circuit islands with a protective coating does not fall below a second minimum distance of e.g. 0.5 mm and/or
- within a circuit island does not fall below a third minimum distance of e.g. 0.2 mm, e.g. with or without a protective coating.

22. The lubricant dispenser according to any one of Claims 1 to 21, **characterized in that** the microcontroller (10) and additional functional components form a common (first) circuit island (E1), wherein the functional components in this circuit island (E1) are only supplied with voltage through the microcontroller.

23. The lubricant dispenser according to any one of Claims 1 to 22, **characterized in that** the circuit arrangement in one circuit island (E6), e.g. on the main board, comprises a motor controller (21) connected to the motor, which is connected to the non-reduced and unregulated battery voltage (V_{B}), namely preferably without a power-limiting resistor and preferably with a thermal fuse.

24. The lubricant dispenser according to any one of Claims 1 to 23, **characterized in that** the circuit arrangement comprises, in one circuit island (E3), e.g. on the main board, a communication module (18) for wireless communication, e.g. a communication module for Bluetooth communication.

25. The lubricant dispenser according to any one of Claims 1 to 24, **characterized in that** the circuit arrangement is equipped with a board detection feature that detects whether an auxiliary board is being used, **in that** it automatically detects, for example, whether an auxiliary board is plugged into or soldered onto the main board.

26. The lubricant dispenser according to any one of Claims 1 to 25, **characterized in that**, in addition to the power limitation of one or multiple individual circuit islands, a power limitation is implemented between individual, interconnected circuit islands, e.g. by one or multiple intermediate resistors (R4, R5, R6, R7, R8, R9) arranged between two circuit islands.

27. A control board assembly (9) for a lubricant dispenser according to any one of Claims 1 to 26, wherein the control board assembly (9) has at least one main board (9a) with an electronic circuit arrangement with at least one central microcontroller (10) and additional electronic functional components and conductor tracks (11), **characterized in that** the electronic circuit arrangement is divided into multiple circuit islands (E1 to E9) or has multiple circuit islands, wherein some or all of the circuit islands are each power-limited.

## Revendications

1. Distributeur (1) de lubrifiant, comprenant au moins
- une réserve (2) de lubrifiant,
- un entraînement (7) électromécanique, qui agit sur au moins un élément d'actionnement (4) pour expulser du lubrifiant hors de la réserve (2) de lubrifiant,
- une batterie (8), laquelle met à disposition une tension de batterie (V_{S}),
- un ensemble de cartes de contrôle (9), qui comporte au moins une carte principale (9a) pourvue d'un ensemble de circuit électronique avec au moins un microcontrôleur (10) centralisé et des composants fonctionnels additionnels, ainsi que des pistes conductrices (11),
**caractérisé en ce que**
l'ensemble de circuit électronique est divisé en plusieurs ilots de circuit (E1 à E9) ou comporte plusieurs ilots de circuit (E1 à E9), certains ou tous les ilots de circuit étant chacun limité en puissance et
**en ce qu'**un ou plusieurs des ilots de circuit est limité en puissance par chaque fois au moins une résistance (R1, R1', R2, R3) limitatrice de puissance.

2. Distributeur de lubrifiant selon la revendication 1, **caractérisé en ce que** la résistance (R1, R1' R2, R3') limitatrice de puissance respective est une prérésistance.

3. Distributeur de lubrifiant selon la revendication 1 ou 2, **caractérisé en ce qu'**un ou plusieurs ilots de circuit, de préférence ceux exempts d'une limitation de puissance sont équipés chacun d'un thermostat de sécurité, qui est fixé, par exemple collé sur la carte, dans la zone de l'ilot de circuit.

4. Distributeur de lubrifiant selon l'une quelconque des revendications 1 à 3, **caractérisé en ce que** l'entraînement (7) électromécanique est conçu sous la forme d'un moteur à courant continu, de préférence d'un moteur à courant continu sans balais (BLDC) ou en comprend un tel.

5. Distributeur de lubrifiant selon l'une quelconque des revendications 1 à 4, **caractérisé en ce que** les écarts entre les pistes conductrices (11) entre des ilots de circuit individuels ne sont pas inférieurs à un écart minimum, de préférence ledit écart minimum étant supérieur à l'écart entre les pistes conductrices à l'intérieur d'un ilot de circuit ou à l'intérieur des ilots de circuit.

6. Distributeur de lubrifiant selon l'une quelconque des revendications 1 à 5, **caractérisé en ce que** l'ensemble de circuit est muni d'un ou connecté avec un dispositif limiteur de courant (22), qui limite l'énergie totale à l'intérieur de (tout) l'ensemble de circuit.

7. Distributeur de lubrifiant selon la revendication 6, **caractérisé en ce que** le dispositif limiteur de courant (22) est conçu à redondance multiple et comprend de préférence plusieurs, par exemple trois limiteurs de courant (22a, b, c), qui sont par exemple montés en parallèle.

8. Distributeur de lubrifiant selon la revendication 6 ou 7, **caractérisé en ce que** le dispositif limiteur de courant (22) comprend (additionnellement) un fusible (24), par exemple un fusible de sécurité.

9. Distributeur de lubrifiant selon l'une quelconque des revendications 1 à 8, **caractérisé en ce que** l'ensemble de circuit est muni d'un ou connecté avec un dispositif régulateur de tension (23), lequel réduit la tension de batterie (V_{S}) à une tension de service (V_{R}) régulée.

10. Distributeur de lubrifiant selon la revendication 9, **caractérisé en ce que** le dispositif régulateur de tension (23) est conçu à redondance multiple et comprend de préférence plusieurs, par exemple trois régulateurs de tension (23a, b, c), qui de préférence sont montés en série.

11. Distributeur de lubrifiant selon la revendication 10, **caractérisé en ce qu'**en tant que chaque fois un ilot de circuit (E7, E8, E9), le ou les régulateur(s) de tension (23a, b, c) sont séparément limités en puissance, par exemple par chaque fois une résistance (R3) limitatrice de puissance.

12. Distributeur de lubrifiant selon l'une quelconque des revendications 1 à 11, **caractérisé en ce que** l'ensemble de cartes de contrôle (9) comprend additionnellement à la carte principale (9a) une carte additionnelle (9b) connectée avec celle-ci, qui est posée par exemple sur la carte principale.

13. Distributeur de lubrifiant selon la revendication 12, **caractérisé en ce que** le dispositif limiteur de courant (22) est posé sur la carte additionnelle (9b), le dispositif limiteur de courant (22) limitant de préférence le courant affluant dans la carte principale (9a).

14. Distributeur de lubrifiant selon la revendication 12 ou 13, **caractérisé en ce que** le dispositif régulateur de tension (23) est placé partiellement ou totalement sur la carte principale et / ou est placé partiellement ou totalement sur la carte additionnelle (9b), **en ce que** par exemple un ou plusieurs régulateurs de tension (23b, c) sont placés sur la carte additionnelle (9b).

15. Distributeur de lubrifiant selon la revendication 14, **caractérisé en ce qu'**au moins un régulateur de tension (23a) est placé sur la carte principale (9a) et un ou plusieurs régulateurs de tension (23b, c) sont placés sur la carte additionnelle (9b).

16. Distributeur de lubrifiant selon la revendication 14, **caractérisé en ce que** tous les régulateurs de tension (23a, 23b, 23c), par exemple tous les trois régulateurs de tension (23a, 23b, 23c) sont placés sur la carte additionnelle (9b).

17. Distributeur de lubrifiant selon l'une quelconque des revendications 14 à 16, **caractérisé en ce que** tous les régulateurs de tension (23a, b, c) sur la carte additionnelle (9b) sont équipés d'un thermostat de sécurité, de préférence un thermostat de sécurité commun étant collé sur tous les régulateurs de tension sur la carte additionnelle.

18. Distributeur de lubrifiant selon l'une quelconque des revendications 1 à 17, **caractérisé en ce que** l'ensemble de circuit est muni par endroits ou totalement d'un revêtement protecteur isolant électrique, par exemple d'un vernis protecteur.

19. Distributeur de lubrifiant selon la revendication 18, **caractérisé en ce que** l'ensemble de circuit sur la carte principale (9a) est enrobé d'un revêtement protecteur, par exemple d'un vernis protecteur.

20. Distributeur de lubrifiant selon la revendication 17 ou 18, **caractérisé en ce que** la carte additionnelle (9b) est munie par endroits ou totalement d'un revêtement protecteur, par exemple est enveloppée partiellement ou totalement sur une face ou sur les deux faces d'un revêtement protecteur, par exemple est coulée ou injectée dans un revêtement protecteur.

21. Distributeur de lubrifiant selon l'une quelconque des revendications 1 à 20, **caractérisé en ce que** les écarts entre les pistes conductrices (11) ne dépassent pas
- un premier écart minimum prédéfini de par exemple 1,5 mm entre des ilots de circuit individuels sans un revêtement protecteur et / ou
- un deuxième écart minimum de par exemple 0,5 mm entre des ilots de circuit individuels avec un revêtement protecteur et / ou
- un troisième écart minimum de par exemple 0,2 mm à l'intérieur d'un ilot de circuit, par exemple avec ou sans revêtement protecteur.

22. Distributeur de lubrifiant selon l'une quelconque des revendications 1 à 21, **caractérisé en ce que** le microcontrôleur (10) forme conjointement avec d'autres composants fonctionnels un (premier) ilot de circuit (E1) commun, les composants fonctionnels dans ledit ilot de circuit (E1) n'étant alimentés en tension que par l'intermédiaire du microcontrôleur.

23. Distributeur de lubrifiant selon l'une quelconque des revendications 1 à 22, **caractérisé en ce que** l'ensemble de circuit dans un ilot de circuit (E6), comprend par exemple sur la carte principale, un circuit moteur (21) connecté avec le moteur, qui est raccordé sur la tension de batterie (V_{S}) non réduite et non régulée, à savoir de préférence sans résistance limitatrice de puissance et de préférence avec un thermostat de sécurité.

24. Distributeur de lubrifiant selon l'une quelconque des revendications 1 à 23, **caractérisé en ce que** l'ensemble de circuit dans un ilot de circuit (E3), comprend par exemple sur la carte principale, un module de communication (18) pour une communication sans fil, par exemple un module de communication pour une communication par Bluetooth.

25. Distributeur de lubrifiant selon l'une quelconque des revendications 1 à 24, **caractérisé en ce que** l'ensemble de circuit est équipé d'une identification de carte, qui identifie l'utilisation d'une carte additionnelle, **en ce que** par exemple, il est automatiquement identifiable, si une carte additionnelle est emboîtée ou brasée sur la carte principale.

26. Distributeur de lubrifiant selon l'une quelconque des revendications 1 à 25, **caractérisé en ce qu'**additionnellement à une limitation de puissance d'un ou de plusieurs ilots de circuit, entre des ilots de circuit individuels, connectés les uns avec les autre est réalisée une limitation de puissance, par exemple par une ou plusieurs résistances (R4, R5, R6, R7, R8, R9) placées entre deux ilots de circuit.

27. Ensemble de cartes de contrôle (9), configurées pour un distributeur de lubrifiant selon l'une quelconque des revendications 1 à 26, l'ensemble de cartes de contrôle (9) comportant au moins une carte principale (9a) pourvue d'un ensemble de circuit électronique, avec au moins un microcontrôleur (10) centralisé et des composants fonctionnels électroniques additionnels, ainsi que des pistes conductrices (11), **caractérisé en ce que** l'ensemble de circuit électronique est divisé en plusieurs ilots de circuit (E1 à E9) ou comporte plusieurs ilots de circuit, certains ou tous les ilots de circuit étant chaque fois limité en puissance.
